(19)

Europäisches
Patentamt
European
Patent Office
Office européen
des brevets

(11) **EP 2 579 048 A1**

(12) **EUROPEAN PATENT APPLICATION**
published in accordance with Art. 153(4) EPC

(43) Date of publication:
**10.04.2013 Bulletin 2013/15**

(51) Int Cl.:
***G01R 19/00*** (2006.01)

(21) Application number: **11789609.2**

(22) Date of filing: **17.05.2011**

(86) International application number:
**PCT/JP2011/061274**

(87) International publication number:
**WO 2011/152200 (08.12.2011 Gazette 2011/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.05.2010 JP 2010123730**

(71) Applicant: **Sanyo Electric Co., Ltd.
Osaka 570-8677 (JP)**

(72) Inventor: **OHKURA Kazumi
Moriguchi-Shi
Osaka 570-8677 (JP)**

(74) Representative: **Glawe, Delfs, Moll
Patent- und Rechtsanwälte
Postfach 26 01 62
80058 München (DE)**

(54) **BATTERY SYSTEM, ELECTRIC VEHICLE, MOBILE BODY, ELECTRIC POWER STORAGE DEVICE, ELECTRIC POWER SUPPLY DEVICE, AND BATTERY VOLTAGE DETECTION DEVICE**

(57)     A voltage detection section 10 comprises an A/D converter section 13 that outputs an A/D detection voltage value (Vad) for batteries 2[i] and voltage level determination sections 16[i] that output a level determination signal, which are the results of comparisons of an analog voltage signal for the batteries 2[i] and a plurality of reference voltages. In the process of the battery voltage increasing or decreasing, the level determination signal changes when the analog voltage signal for the batteries 2[i] exceeds or falls below any of the reference voltages. A level determination voltage value shown by the level determination signal at that change timing and the A/D detection voltage value (Vad) are compared, and an occurrence of an in-range failure is detected when there is a difference between the two. In this instance, if the batteries are charging, a correction that increases A/D detection voltage value is made using the ratio and difference of the determination voltage value at that change timing and the A/D detection voltage value, and if the batteries are discharging, a change that decreases the A/D detection voltage value is made using the this ratio and difference.

[Figure 1]

EP 2 579 048 A1

**Description**

**FIELD OF THE INVENTION**

The present invention relates to a battery system provided with a battery voltage value detection function and a battery voltage detection device. The present invention further relates to an electric vehicle, moving body, electric power storage device and power supply device that use this battery system.

**BACKGROUND OF THE INVENTION**

Abnormalities arise (accurate detection of analog voltages not being possible) in voltage detection devices that detect analog voltages for the objects of measurements using A/D converters if the signal lines that transmit analog voltage signals are broken or failures occur in the A/D converters themselves. On the other hand, the range of voltages that can be obtained for the analog voltage that is the object of measurements in a normal state is known in advance in these voltage detection devices.

Therefore, an abnormality can easily be detected if the output voltage value for an A/D converter is an abnormally high or abnormally low voltage value that should not be obtained for the analog voltage that is the object of measurements (in other words, not within the range of this voltage). However, even if the output voltage value for the A/D converter is within this range of voltages, there are comparatively mild failures that do not fall within the detection precision that can be expected. Such failures are called in-range failures. The state in which the absolute value for the difference between the output voltage for the A/D converter and the true value for the measured analog voltage is equal to or less than a predetermined allowable difference corresponds to the state that falls within the detection precision. The state in which that absolute value exceeds the allowable difference corresponds to the state that does not fall within the detection precision.

For example, when the object of measurements is a lithium ion secondary battery, approximately 4.2 V and approximately 2.0 V (volts) can, for example, be used for the voltage values that give an indication of overcharging and excessive discharging of the lithium ion secondary battery. Therefore, overcharging or excessive discharging, which are types of abnormalities, can be detected when the output voltage value for the A/D converter exceeds 4.2 V or is less than 2.0 V. However, when the actual voltage value for object of measurements is 3.6 V, and the output voltage for the A/D converter shows 3.3 V because of a precision abnormality in the A/D converter, the control system recognizes the voltage value for the object of measurements as being 3.3 V. A precision abnormality that makes 3.6 V be detected as 3.3 V is one type of in-range failure.

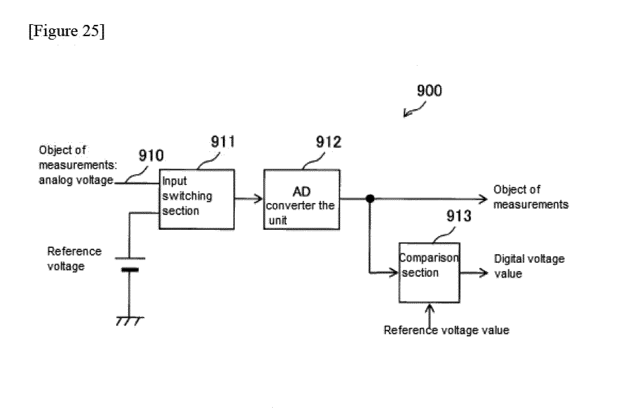

Figure 25 is a internal block diagram of a voltage detection device 900 that gives an in-range failure of this nature to the detection (see Patent Reference 1, for example). While, in the voltage detection device 900, voltage detection line 910 in which an analog voltage signal for the analog voltage that is the object of measurements is connected to a first terminal of a voltage switching section 911 comprising a multiplexer and the like, a reference voltage having a known reference voltage value is input to a second terminal of the voltage switching section 911. The analog voltage that is the object of measurements and the reference voltage are input to an A/D converter 912 by a selection operation in the voltage switching section 911. A comparator 913 can detect the presence or absence of an in-range failure from the difference in the output voltage value for the A/D converter 912 and the reference voltage value when the reference voltage is input to the A/D converter 912. In other words, if the absolute value for that difference is a prescribed threshold value (for example, 10 mV) or greater, the occurrence of an in-range failure can be determined.

In addition, a method for detecting an error state within the measured value detection range when a measured value that has been converted by the A/D converter and a signal of a prescribed signal level introduced from this measured value are compared and a difference equal to or greater than the allowable range between those signal values is detected has been disclosed (for example, see Patent Reference 2).

**DOCUMENTS OF PRIOR ART**

[Patent Documents]

Cited Patent 1: Published Unexamined Patent Application No. H10-209864
Cited Patent 2: Published Unexamined Patent Application No. H8-303292

## SUMMARY OF THE INVENTION

Problems to be Solved by the Invention

In equipment driven using batteries, various types of control, including charging and discharging control for the batteries using detection results for battery voltage, are carried out. Electric vehicles and the like are included in equipment driven using batteries. When occurrences of in-range failures are detected, the operation of an electric vehicle can be stopped immediately. However, in-range failures are comparatively mild failures; therefore, it cannot always be said that immediately stopping the operation of the electric vehicle when an in-range failure is detected is always the best measure. For example, when the true value for the voltage of a lithium ion secondary battery, which is the voltage source, is 3.4 V and when an in-range failure that offsets the detection results for the battery by 10 mV occurs, it is not always appropriate to immediately stop the operation of the electric vehicle. The reason is that electrical power can be safely extracted from the lithium ion secondary battery at 3.39 - 3.41 V. In addition, supplying a charging current to the lithium ion secondary battery at 3.39 - 3.41 V is not a problem.

However, even when in-range failures occur, the battery going into an overcharged state or an excessively discharged state should be avoided, and it is also important to continuously detect battery voltage during in-range failures to avoid occurrences of overcharging states and excessive discharging states. In such instances, system safety is increased if voltage detection results that can avoid occurrences of overcharging states or excessive discharging states safely are generated. Moreover, in Patent References 1 and 2, only methods for protecting in-range failures and states corresponding to in-range failures are disclosed, and response methods after the occurrence of in-range failures are not disclosed.

Thus, it is an object of the present invention to provide a battery system and battery voltage detection device that can carry out appropriate voltage value detection when in-range failures are detected. In addition, it is a further object of the present invention to provide an electric vehicle, moving body, electric power storage device and power supply device that use this battery system.

Means to Solve the Problems

A first battery system according to the present invention comprises a battery for a voltage source of an analog voltage that is the object of measurements and which can be charged and discharged and a voltage detection section that has an A/D converter section that converts an analog voltage signal for the analog voltage that is the object of measurements to a digital voltage signal and outputs an A/D detection voltage value according to that digital voltage signal and a voltage level determination section that outputs a level determination signal that expresses size relationships between the analog voltage that is the object of measurements and various reference voltages by comparing the analog voltage that is the object of measurements with a plurality of reference voltages and detects the output voltage value for the battery from the A/D detection voltage value. This battery system further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value. When the battery is charging and when the occurrence of a failure at the first time is detected, the output voltage value is detected at a second time based on the determination voltage value at the first time and the A/D detection voltage value at the second time which is a time matching the first time or subsequent to the first time.

A second battery system according to the present invention comprises a battery for a voltage source of an analog voltage that is the object of measurements and which can be charged and discharged and a voltage detection section that has an A/D converter section that converts an analog voltage signal for the analog voltage that is the object of measurements to a digital voltage signal and outputs an A/D detection voltage value according to that digital voltage signal and a voltage level determination section that outputs a level determination signal according to the determination results for the analog voltage that is the object of measurements and detects the output voltage value for the battery from the A/D detection voltage value. This battery system further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value. When the battery is charging and when the occurrence of a failure at the first time is detected, the output voltage value is detected at a second time based on the determination voltage value at the first time and the A/D detection voltage value at the second time which is a time matching the first time or subsequent to the first time.

When battery charging is being carried out for the first or second battery system and when a failure is detected in the voltage detection section at the first time, not only the A/D detection voltage value at the second time, but also the determination voltage value at the second time is used, and the output voltage value at the second time is detected.

Thus, for example, the A/D detection voltage value at the second time can be corrected by the determination voltage value at the first time, and the effects of the failure in the voltage detection section can be compensated for. As a result, an output voltage value such that an overcharging state is safely avoided can be continuously detected even when a failure arises in the voltage detection section.

For example, when the battery is discharging in the first or second battery system and when the occurrence of the failure at the first time is detected, the output voltage value at the second time is detected based on the determination voltage value at the first time and the A/D detection voltage value at the second time.

When the battery is discharging and when a failure is detected in the voltage detection section at the first time, the output voltage value at the second time is detected using not only the A/D detection voltage value at the second time, but also the determination voltage value at the first time. Thus, for example, the A/D detection voltage value at the second time can be corrected by the determination voltage value at the first time, and the effects of the failure in the voltage detection section can be compensated for. As a result, an output voltage value such that an excessive discharging state is safely avoided can be continuously detected even when a failure arises in the voltage detection section.

More specifically, for example, when the battery is being charged in the first or second system, and when the occurrence of a failure is detected at the first time and the determination voltage value detected at the first time is larger than the A/D detection voltage value at the first time, the output voltage value at the second time is detected by a correction that increases the A/D detection voltage at the second time using either or both of the ratio of the determination voltage value at the first time and the A/D detection voltage value and difference between the determination voltage value at the first time and the A/D detection voltage value.

When a failure occurs in the voltage detection section, an appreciable detection error is included in the determination voltage value or A/D detection voltage value. On the other hand, information on this detection error is included in the ratio and the difference above. Thus, during failure detection, the A/D detection voltage value is corrected using either or both of the ratio and the difference above, and the output detection voltage value is generated accordingly. If, in this instance, charging of the battery is being carried out, a correction is made that increases the A/D detection voltage value, and thereby a voltage value that is safe in terms of overcharging can be detected as the output voltage value.

More specifically, for example, when the battery is being discharged in the first or second system, and when the occurrence of a failure is detected at the first time and the determination voltage value detected at the first time is smaller than the A/D detection voltage value at the first time, the output voltage value at the second time is detected by a correction that decreases the A/D detection voltage at the second time using either or both of the ratio of the determination voltage value at the first time and the A/D detection voltage value and difference between the determination voltage value at the first time and the A/D detection voltage value.

When a failure occurs in the voltage detection section, an appreciable detection error is included in the determination voltage value or A/D detection voltage value. On the other hand, information on this detection error is included in the ratio and the difference. Thus, during failure detection, the A/D detection voltage value is corrected using either or both of the ratio and the difference above, and the output detection voltage value is generated accordingly. In this instance, if the battery is being discharged, a voltage value that is safe in terms of excessive discharging can be detected as the output voltage value by making a correction that decreases the A/D detection voltage value.

More specifically, for example, when the battery is being charged in the first or second system, and when the occurrence of a failure is detected at the first time, a voltage value that is equal to or greater than the determination voltage value at the first time is established for comparison, and the larger of the voltage value for comparison and the A/D detection voltage value at the second time is detected as the detection voltage value at the second time.

When the occurrence of a failure is detected during charging of the battery, a voltage value that is safe in terms of overcharging can be detected as the output voltage value by selecting the larger of the candidates for the output voltage value as the output voltage value.

More specifically, for example, when the battery is being charged in the first or second system and when the occurrence of a failure is detected at the first time, a voltage value that is equal to or less than the determination voltage value at the first time is established for comparison, and the smaller of the value for comparison and the A/D detection voltage value at the second time is detected as the output voltage value at the second time.

When the occurrence of a failure is detected during discharging of the battery, a voltage value that is safe in terms of excessive discharging can be detected as the output voltage value by selecting the smaller of the candidates for the output voltage value as the output voltage value.

In addition, for example, the failure detection section can detect whether or not the A/D detection voltage value is in a specific abnormal state based on the A/D detection voltage value, and when the A/D detection voltage value is detected as being in a specific abnormal state, the battery system detects the voltage value corresponding to the determination voltage value as the output voltage value.

Thus, even when the input signal line to the A/D converter section is broken, continuous detection of the output voltage value can be continued, and charging and discharging control of the battery can be carried out using the results thereof.

In addition, for example, a battery state detection section that detects either or both of the internal resistance value of the battery and the remaining capacity of the battery based on the output voltage value that is detected can be further provided in the first or second battery system.

An error is included in the A/D detection voltage value because of the failure; therefore, if the internal resistance value or the like is detected based on the A/D detection voltage value itself, the effect of the failure will appear unaltered in the internal resistance value or the like. Thus, the internal resistance value or the like is detected using an output voltage value that is detected with consideration given to the effects of the failure. Therefore, an internal resistance value or the like in which the error due to the failure is compensated for or considered can be obtained.

An electric vehicle according to the present invention is characterized by being provided with the first or second battery system and also being provided with a rotating motor that uses the output of the battery in the battery system, drive wheels that drive by the rotation of the motor and a vehicle control section that controls the rotational state of the motor based on the output voltage value detected in the battery system.

By providing one of the battery systems above to the electric vehicle and carrying out rotational control of the motor based on the output voltage value detected in the battery system, the vehicle can continue operating while safely avoiding overcharging and excessive discharging even when the failure arises in the voltage detection section.

The moving body according to the present invention is characterized by being provided with the first or second battery system and also being provided with a moving body main part, a mechanical power source that converts the electric power from the battery in the battery system to mechanical power and a drive section that moves the moving body main part by the mechanical power from the mechanical power source.

By providing the first or second battery system in the moving body, for example, moving control of the moving body can be continued while safely avoiding overcharging and excessive discharging even when a failure arises in the voltage detection section.

The electric power storage device according to the present invention is characterized by being provided with the first or second battery system and also being provided with a charging and discharging control unit that carries out control related to charging and discharging of the battery in the battery system.

By providing the first or second battery system in the electric power storage device, for example, storage or discharge of electric power can be continued while safely avoiding overcharging and excessive discharging even when a failure arises in the voltage detection section.

The power supply device according to the present invention is a power supply device that can be connected to external equipment or a power system and is characterized by being provided with the electric power storage device and an electric power conversion device that carries out electric power conversion between the battery in the electric power storage device and the external equipment or power system under the control of the charging and discharging control unit in the electric power storage device.

According to this power supply device, for example, operation as a power supply device can be continued while safely avoiding overcharging and excessive discharging even when a failure occurs in the voltage detection section.

A first battery voltage detection device according to the present invention is provided with a voltage detection section that has an A/D converter section that converts an analog voltage signal for the analog voltage that is output by a battery that can be charged and discharged and that is the object of measurements to a digital voltage signal and outputs an A/D detection voltage value according to that digital voltage signal and a voltage level determination section that outputs a level determination signal that expresses size relationships between the analog voltage that is the object of measurements and various reference voltages by comparing the analog voltage that is the object of measurements with a plurality of reference voltages and detects the output voltage value for the battery from the A/D detection voltage value. This voltage detection device is characterized by further being provided with a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value. When the battery is charging and when the occurrence of a failure at the first time is detected, the output voltage value is detected at a second time based on the determination voltage value at the first time and the A/D detection voltage value at the second time, which is a time matching the first time or subsequent to the first time.

A second battery voltage detection device according to the present invention is provided with a voltage detection section that has an A/D converter section that converts an analog voltage signal for the analog voltage that output by a battery that can be charged and discharged and that is the object of measurements to a digital voltage signal and outputs an A/D detection voltage value according to that digital voltage signal and a voltage level determination section that outputs a level determination signal corresponding to the determination results for the analog voltage that is the object of measurements and detects the output voltage value for the battery from the A/D detection voltage value. This voltage detection device is characterized by further being provided with a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value. When the battery is charging and when the occurrence of a failure at the first time is detected, the output voltage value is detected at a second time based on the determination voltage value at the first time and the A/D detection voltage value at the second time which is a time matching the first time or subsequent to the first time.

When battery charging is being carried out for the first or second battery voltage detection device and when a failure is detected in the voltage detection section at the first time, not only the A/D detection voltage value at the second time, but also the determination voltage value at the second time is used, and the output voltage value at the second time is detected. Thus, for example, the A/D detection voltage value at the second time can be corrected by the determination voltage value at the first time, and the effects of the failure in the voltage detection section can be compensated for. As a result, an output voltage value such that an overcharging state is safely avoided can be continuously detected even when a failure arises in the voltage detection section.

## EFFECTS OF THE INVENTION

According to the present invention, a battery system and battery voltage detection device that can carry out appropriate voltage value detection during detection of in-range failures as well as an electric vehicle, moving body, electric power storage device and power supply device that use that battery system are possible.

## BRIEF DESCRIPTION OF THE DRAWINGS

Figure 1 is a drawing of the internal constitution of a battery system according to an embodiment of the present invention.
Figure 2 is an internal circuit diagram of one voltage level determination section shown in Figure 1.
Figure 3 is an internal circuit diagram of a voltage level determination section obtained by diversion of an overcharging and excessive discharging detection circuit.
Figure 4 is an equivalent circuit diagram of the battery system in a state where a leak current is occurring on the A/D converter section side.
Figure 5 is an equivalent circuit diagram of a circuit between the battery and A/D converter section in a state where a leak current is occurring on the A/D converter section side.
Figure 6 is a drawing showing one voltage level determination section that is focused on out of the plurality of voltage level determination sections shown in Figure 1.
Figure 7 is a drawing showing examples by giving failure causes that invite in-range failures and failure locations.
Figure 8 is a drawing showing voltage waveforms for various voltages in a first case according to a first embodiment of the present invention.
Figure 9 is a drawing showing voltage waveforms for various voltages in a second case according to the first embodiment of the present invention.
Figure 10 is an operational flow chart for the battery system according to the first embodiment of the present invention.
Figure 11 is an operational flow chart for the battery system according to a second embodiment of the present invention. Figure 12 is an operational flow chart for the battery system according to a third embodiment of the present invention. Figure 13 is a drawing showing voltage waveforms for various voltages in case A according to a fourth embodiment of the present invention.
Figure 14 is a drawing showing voltage waveforms for various voltages in case B according to the fourth embodiment of the present invention.
Figure 15 is a drawing showing voltage waveforms for various voltages in case B according to the fourth embodiment of the present invention.
Figure 16 is a drawing showing voltage waveforms for various voltages in case C according to the fourth embodiment of the present invention.
Figure 17 is a drawing showing voltage waveforms for various voltages in case D according to the fourth embodiment of the present invention.
Figure 18 is an operational flow chart for the battery system according to the fourth embodiment of the present invention.
Figure 19 shows the formation of a battery system using a plurality of integrated circuits according to a fifth embodiment of the present invention.
Figure 20 is a drawing showing the provision of a battery state detection section in a charging and discharging control section according to a seventh embodiment of the present invention.
Figure 21 is a drawing showing the provision of a current sensor between a voltage source section and a charging and discharging section according to the seventh embodiment of the present invention.

Figure 22 is an internal equivalent circuit diagram of a battery envisioned for the seventh embodiment of the present invention.

Figure 23 is an external appearance surface drawing (a) of an electric vehicle according to an eighth embodiment of the present invention and a schematic block diagram of a drive system for the electric vehicle.

Figure 24 is a drawing showing a battery voltage detection device present internally in a constitution according to the present invention.

Figure 25 is an internal block diagram of a conventional voltage detection device.

Figure 26 is a drawing showing the constitution of a voltage level determination section according to a tenth embodiment of the present invention.

Figure 27 is a drawing showing the constitution of a power supply device according to a twelfth embodiment of the present invention.

## MODE FOR CARRYING OUT THE INVENTION

In the following, a specific description will be given with embodiments of the present invention and reference to the drawings. In the various drawings that are referenced, the same parts are given the same element numbers, and duplicate descriptions of identical parts will be omitted as a general rule.

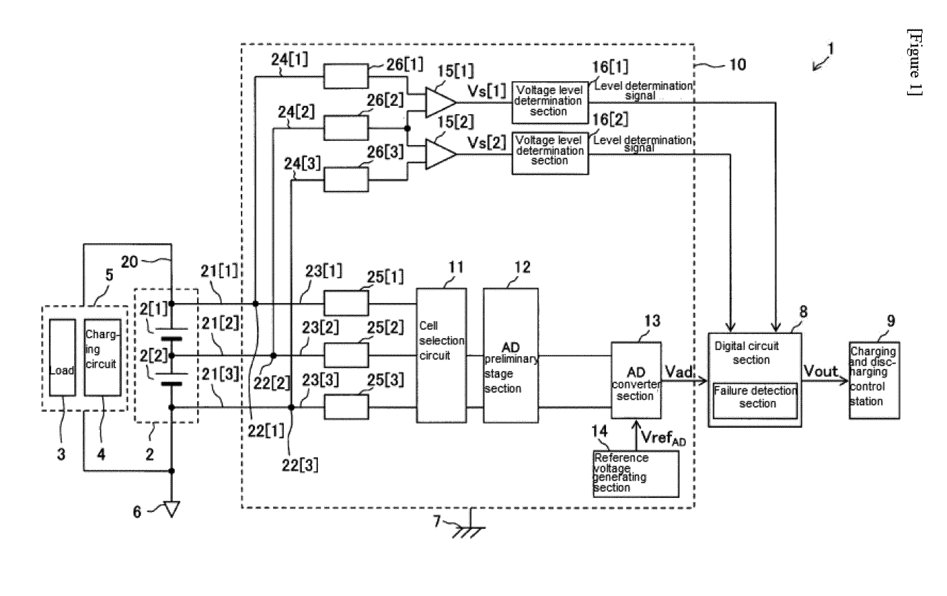

Figure 1 is a drawing of the internal constitution of a battery system 1 according to an embodiment of the present invention. A battery system 1 is constituted so as to include at least a voltage source section 2, voltage detection section 10 and digital circuit section 8. Inclusion of a charging and discharging section 5, a charging and discharging control section 9, or both of these in the battery system 1 may be considered. In addition, in the example in Figure 1, the digital circuit section 8 is provided outside of the voltage detection section 10, but inclusion of the digital circuit section 8 in the voltage detection section 10 may be considered. The voltage detection section 10 comprises various parts referenced by element numbers 11 - 14, 15[i] and 16[i]. i is an integer.

In Figure 1, voltage sources 2[1] and 2[2] are shown as objects of voltage measurements. In the present embodiment, the objects of measurements are chargeable lithium ion secondary batteries unless specifically described, and the voltage sources are called batteries. A circuit in which the batteries 2[1] and 2[2] are connected in series is the voltage source section 2. The battery 2[1] is positioned on the high voltage side, and the negative output terminal of the battery 2[1] is connected to the positive output terminal of the battery 2[2]. Moreover, in the present example, the number of batteries forming the voltage source section 2 is two, but that number may be one or three or more. When that number is one, a cell selection circuit 11 is unnecessary, and one is sufficient for the number of both a buffer amplifier 15[1] and the voltage level determination section 16[i]. In addition, a circuit that connects a plurality of batteries in parallel may be the voltage source section 2, and within the voltage source section 2, a circuit that connects a plurality of batteries in series and a circuit that connects a plurality of batteries in parallel may coexist. In addition, a plurality of circuits that connect a plurality of batteries in series may be provided in the voltage source section 2, and that plurality of series connected circuits may be connected in parallel.

A load 3 is driven by the output voltage of the voltage source section 2. A charging circuit 4 is a circuit for charging the various batteries 2[i] in the voltage source section 2. In the example in Figure 1, the output voltage of the voltage source section 2 is the output voltage of the series connected circuit for the batteries 2[1] and 2[2]. The part formed by the load 3 and charging circuit 4 is called the charging and discharging section 5.

Voltage detection lines 21[1] - 21[3] are taken off of a ring-shaped main power line 20 that connects the voltage source section 2 and load 3 with the charging circuit 4. The voltage detection lines 21[1], 21[2] and 21[3] are connected to the contact point of the negative output terminal of the battery 2[1], the positive output terminal of the battery 2[2] and the negative output terminal of the battery 2[2], respectively. The negative output terminal of the battery 2[2] is connected to a reference potential point 6. A voltage detection section 10, the digital circuit section 8 and charging and discharging control section 9 operate with the potential at a reference potential point 7 as a reference. The potential at the reference potential points 6 and 7 may be the same or may not be the same. To simplify the description in the following description, the reference potential points 6 and 7 are made to be the same.

The voltage detection lines 21[i] branch in two at branch points 22[i], and one side is connected to a selection circuit 11 and the other side connected to a buffer amplifier 15[1] or 15[2]. The voltage detection lines from the branch points 22[i] to the cell selection circuit 11 are referred to by element number 23[i], and the voltage detection lines from the branch points 22[i] to the buffer amplifier 15[1] or 15[2] are referred to by element number 24[i]. Therefore, the signals in the voltage detection lines 21[i] are branched at the branch points 22[i], and are further transmitted in the voltage detection lines 23[i] and 24[i]. The signal transmitted in each voltage detection line is an analog voltage signal. Moreover, the distribution lines that transmit signals, including the voltage detection lines are called signal lines.

One current suppressing element is provided in series on each of the voltage detection lines 23[1] - 23[3] and 24[1] - 24[3]. The current suppressing elements provided on the voltage detection lines 23[i] are represented by 25[i], and the current suppressing elements provided on the voltage detection lines 24[i] are represented by 26[i]. Each of the current suppressing elements is a resistor that restrains the size of the current that is trying to flow through itself from the voltage source section 2 when a short or the like occurs. Each current suppressing element can use a simple resistor (carbon film resistor), but preferably uses a PTC (positive temperature coefficient) or the like thermistor. Moreover, when each of the current suppressing elements is a simple resistor, a PTC or the like thermistor may be provided on the voltage detection lines 21[i]. In addition, current suppressing elements 25[i] may be disposed on voltage detection lines 21[i] between the voltage source section 2 and branch points 22[i] while eliminating current suppressing elements 26[i].

As is clear from the description above, the branch points 22[i] are connected to the selection circuit 11 via the voltage detection lines 23[i] and the current suppressing elements 25[i]. In addition, the branch point 22[1] is connected to a positive input terminal of the buffer amplifier 15[1] via the voltage detection line 24[1] and the current suppressing element 26[1]. The branch point 22[2] is connected to a negative input terminal of the buffer amplifier 15[1] and the positive input terminal of the buffer amplifier 15 [2] via the voltage detection line 24[2] and the current suppressing element 26[2]. The branch point 22[3] is connected to the negative input terminal of the buffer amplifier 15 [2] via the voltage detection line 24[3] and the current suppressing element 26[3].

The buffer amplifiers 15[i] output voltages across the positive and negative input terminals with the potential of the negative input terminal as a reference. The output voltages of the buffer amplifiers 15[i] are represented by Vs[i]. Therefore, the voltage across the voltage detection lines 24[1] and 24[2] is output from the buffer amplifier 15[1] with the potential of the voltage detection line 24[2] as a reference, and the voltage across the voltage detection lines 24[2] and 24[3] is output from the buffer amplifier 15[2] with the potential of the voltage detection line 24[3] as a reference. Therefore, the output voltages Vs[i] represent the output voltages of the batteries 2[i]. The output voltages Vs[i] for the buffer amplifiers 15[i] are sent to voltage level determination sections 16[i].

A cell selection circuit 11 is formed from a multiplexer or the like, and the analog voltage signal across the voltage detection lines 23[1] and 23[2] and the analog voltage signal across the voltage detection lines 23[2] and 23[3] are selected in order and periodically. Two lines from the voltage detection lines 23[1] - 23[3] are selected so that conversion to a digital voltage signal is carried out in an A/D converter section 13. The voltage detection lines selected are connected to an A/D preliminary stage section 12 as an analog front end. In other words, the voltage detection lines 23[1] and 23 [2] and the voltage detection lines 23[2] and 23[3] are selected in order and periodically and connected to the A/D preliminary stage section 12.

The A/D preliminary stage section 12 is a buffer circuit for transferring the voltage across two voltage detection lines [i] and [i+1] selected by the cell selection circuit 11 to the A/D converter section 13 as voltages for A/D conversion and, for example, is formed from a difference amplifier and flying capacitor.

The A/D converter section 13 periodically converts the voltage that has been transmitted from the A/D preliminary stage section 12 and that is the object of A/D conversion to a digital voltage while using an A/D reference voltage VrefAD, which is generated by a reference voltage generating section 14, as a reference. In other words, the analog voltage signal that represents the voltage that is the object of A/D conversion is converted into a digital voltage signal. The digital voltage signal obtained is output to the digital circuit section 8. The voltage value represented by the digital voltage signal from the A/D converter section 13 is represented by Vad, and that voltage value is called an A/D detection voltage value.

Ideally, the voltage level determination sections 16[i] would have voltages Vs[i] that match the output voltages of the batteries 2[i] as the objects of measurements, and a level determination signal that represents the size relationship between the voltages Vs[i] and various reference voltages is output by comparing voltages Vs[i], which are the analog voltages that are the objects of measurements, with a plurality of reference voltages.

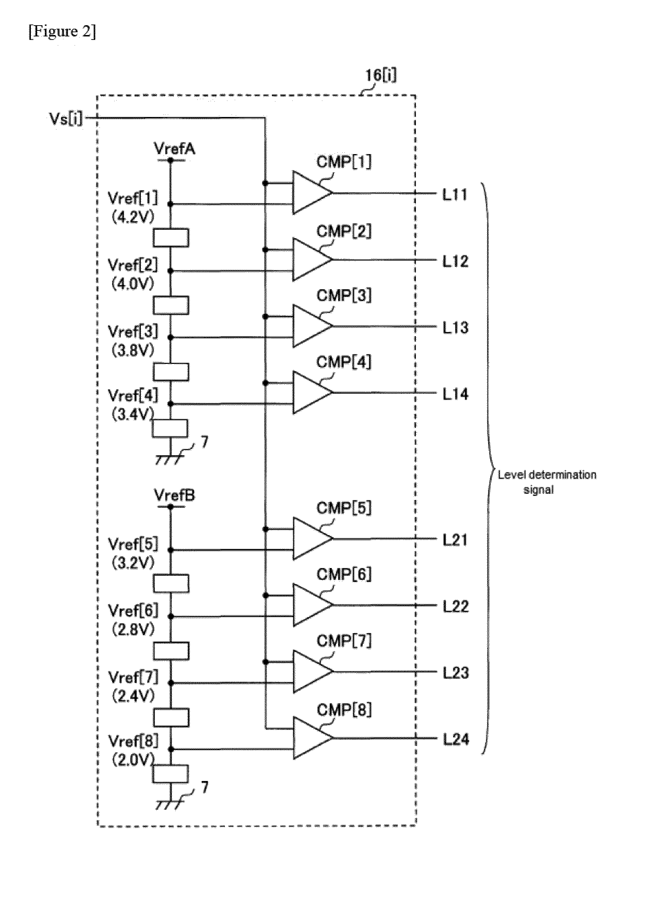

The constitutions of the voltage level determination sections 16[1] and 16[2] are the same. Figure 2 shows an internal circuit diagram of one voltage level determination section 16[i]. The voltage level determination section 16[i] comprises eight comparators CMP[1] - CMP[8]. The comparators CMP[1] - CMP[8] are the same as each other.

The comparators CMP[j] have first and second output terminals, and when the voltage applied to a first input terminal is higher than the voltage applied to a second input terminal, a signal that has a "1" value (logical value) is output by the output terminals. When the voltage applied to the first input terminal is lower than the voltage applied to the second input terminal, a signal that has a "0" value (logical value) is output by the output terminals. Here, j is an integer. In the comparators CMP [j] in the voltage level determination sections 16[i], the voltages Vs[i] from the buffer amplifiers 15[i] are applied to the first input terminals, and reference voltages Vref[j], which have prescribed voltage values, are applied to the second input terminals. The reference voltages applied to the second input terminals are different from each other among comparators CMP[1] - CMP[8], and the reference voltages Vref[j] for the second input terminals of the comparators CMP[j] are higher than the reference voltages Vref[j+1] for the second input terminals of the comparators CMP[j+1]

In the present example, the values for the reference voltages Vref[1] - Vref[8] are set, respectively, at 4.2 V, 4.0 V, 3.8 V, 3.4 V, 3.2 V, 2.8 V, 2.4 V and 2.0 V (V representing volts). Naturally, these specific voltage values are nothing more than examples and may be changed variously. The reference voltages Vref[1] - Vref[4] are generated from a base reference voltage VrefA generated in the voltage detection section 10 and a plurality of voltage dividing resistors, and reference voltages for the reference voltages Vref[5] - Vref[8] are generated from a base reference voltage VrefB generated in the voltage detection section 10 and a plurality of voltage dividing resistors. The base reference voltages VrefA and VrefB can be generated from one reference voltage (for example, an A/D reference voltage VrefAD). In addition, the reference voltages Vref[1] - Vref[8] may be generated separately in separate circuits.

The signals output from the output terminals of the comparators CMP[1] - CMP[8] are represented by L11, L12, L 13, L 14, L21, L22, L23 and L24. Furthermore, the general name for the signals L11, L12, L13, L14, L21, L22, L23 and L24 is level determination signals. The level determination signals from the voltage level determination sections 16[i] can be thought of as single signals representing the voltage values of the batteries 2[i], and the voltage values shown by the level determination signals from the voltage level determination sections 16[i] are called determination voltage values.

The determination voltage values shown by the level determination signal of the voltage level determination sections 16[i] are: 4.2 V when the value for the signal L11 is "1"; 4.0 V when the value for the signal L11 is "0" and the value for the signal L12 is "1"; 3.8 V when the value for the signal L12 is "0" and the value for signal L13 is "1"; 3.4 V when the value for the signal L13 is "0" and the value for the signal L14 is "1"; 3.2 V when the value for the signal 14 is "0" and the value for the signal L21 is "1"; 2.8 V when the value for the signal L21 is "0" and the value for the signal L22 is "1"; 2.4 V when the value for the signal L22 is "0" and the value for the signal L23 is "1"; 2.0 V when the value for the signal L23 is "0" and the value for the signal L24 is "1"; and less than 2.0 V when the value for the signal L24 is "0."

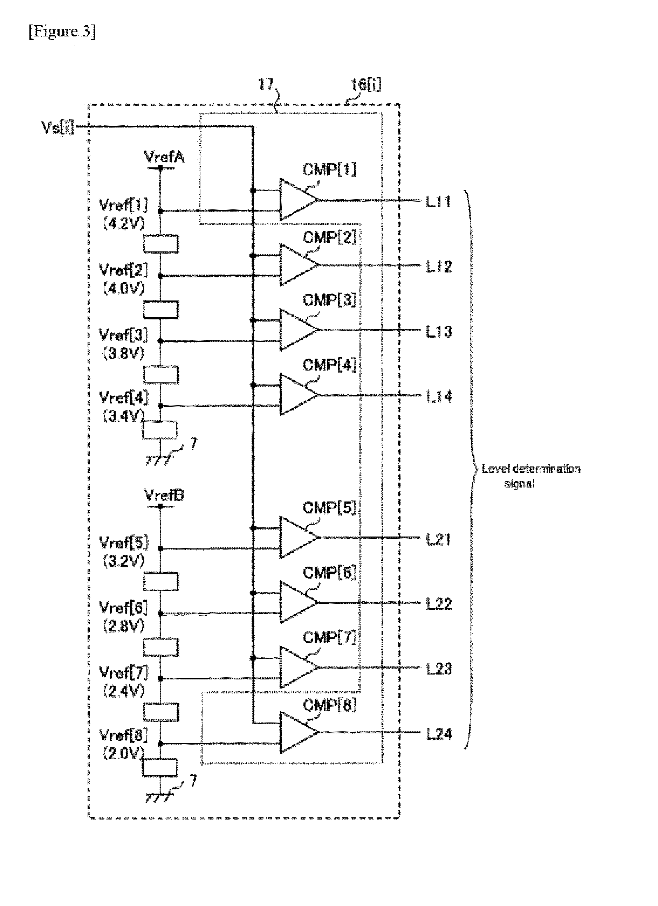

Moreover, the voltage level determination sections 16[i] can be formed by diversion of a conventional overcharging and excessive discharging detection circuit (not shown in the drawings). Figure 3 shows voltage level determination sections 16[i] obtained by diversion of the overcharging and excessive discharging detection circuit 17. The overcharging and excessive discharging detection circuit 17 is formed by including the comparators CMP[1] and CMP [8]. The overcharging and excessive discharging detection circuit 17 detects overcharging or excessive discharging of the batteries 2[i] by respectively comparing a reference voltage for determining overcharging and a reference voltage for determining excessive discharging of the batteries 2[i] using the comparators CMP[1] and CMP[8], and signals L11 and L24 that represent the results thereof are output. Vref[1] is used as the reference voltage for determining overcharging, and Vref[8] is used as the voltage for determining excessive discharging in the overcharging and excessive discharging detection circuit 17. The voltage level determination sections 16[i] are formed by adding comparators CMP[2] - CMP[7], which compare the six reference voltages Vref[2] - Vref[7] other than these with the output voltages of the batteries 2[i] to the overcharging and excessive discharging detection circuit 17. If the voltage level determination sections 16[i] are formed by diversion of the conventional overcharging and excessive discharging detection circuit 17, complication of the constitution and increases in costs are restrained. In addition, the number of reference voltages Vref[j] used by the voltage level determination sections 16[i] can be something other than eight, and accordingly, the number of comparators CMP[j] provided in the voltage level determination sections 16[i] can be something other than eight.

See Figure 1 once again. The level determination signal from each of the voltage level determination sections 16[1] and 16[2] is applied to the digital circuit section 8. The digital circuit section 8 generates a detection value for the output voltage of each battery based on the level determination signal from the voltage level determination section 16 [1] and 16[2] and the digital voltage signal from the A/D converter section 13 and outputs the generated detection value. The detection value output by the digital circuit section 8 is represented by Vout, and this is called the actual detection value.

When the digital voltage signal for the output voltage for the battery 2[1] is being output by the A/D converter section 13, the detection value for the output voltage of the battery 2[1] is output as the actual detection value Vout based on digital voltage signal from the A/D converter section 13 and the level determination signal from the voltage level determination section 16[1]. Likewise, when the digital voltage signal for the output voltage for the battery 2[2] is being output by the A/D converter section 13, the detection value for the output voltage of the battery 2[2] is output as the actual detection value Vout based on digital voltage signal from the A/D converter section 13 and the level determination signal from the voltage level determination section 16[2].

The digital circuit section 8 has a function as a failure detection section and, along with detecting overcharging states and excessive discharging states in the batteries 2[1] and 2[2] based on digital voltage signal from the A/D converter section 13 and the level determination signals from the voltage level determination sections 16[1] and 16[2], detects the presence or absence of failures in the voltage detection section 10.

In-range failures are included in the failures that are detected. Moreover, the detection of overcharging states and excessive discharging states may be interpreted as being carried out in the voltage level determination sections 16[i].

A normal voltage range is determined in advance for the output voltage of the batteries 2[i].

During normal use, the output voltage for the batteries 2[i] is envisioned as falling within that normal voltage range. As in the description above, the batteries 2[i] being lithium ion secondary batteries will be considered. Therefore, as a specific numerical example a normal voltage range that is 2 V and less than 4.2 V will be envisioned. The state in which the output voltage of the batteries 2[i] is 2 V or greater and less than 4.2 V is called the normal usage state. The state in which the output voltage of the batteries 2[i] is 4.2 V or greater is an overcharging state of the batteries 2[i], and the state in which the output voltage of the batteries 2[i] is less than 2 V is an excessive discharging state of the batteries 2[i]. The digital circuit section 8 can carry out detection of overcharging states and excessive discharging states based on the actual detection value Vout. In other words, when the actual detection value Vout for the batteries 2[i] is 4.2 V or higher, a determination can be made that the batteries 2[i] are in an overcharging state, and when that value is less than 2 V, a determination can be made that the batteries 2[i] are in an excessive discharging state.

In-range failures indicate comparatively mild failures in which the A/D detection voltage value Vad for the batteries 2[i] according to the output signal of the A/D converter section 13 does not satisfy the expected detection precision even if the output voltage for the batteries 2[i] for the in-range failures is within the normal voltage range. For example, when the absolute value for the allowable detection error is 10 mV or less and the true output voltage for the batteries 2[i] is 3.600 V, no in-range failure has occurred when the inequality "3.590 ≤ Vad ≤ 3.610" is satisfied, but with the inequality "2.000 ≤ Vad < 3.590" or "3.610 < Vad < 4.200" arises, an in-range failure has occurred (the units of the inequalities above being volts).

When the digital circuit section 8 determines that no in-range failures have occurred in the voltage detection section 10, the A/D detection voltage value Vad itself can be output as the actual detection value Vout. On the other hand, when the occurrence of an in-range failure is determined, the digital circuit section 8, generates and outputs a voltage value on the safe side based on the A/D detection voltage value Vad and the determination voltage values as the actual detection value Vout (details to be described in the following). When the batteries are charging, overcharging must be avoided, and when the batteries are discharging excessive discharging must be avoided. Therefore, a voltage value on the safe side means a voltage comparatively higher during charging of the batteries (for example, a voltage value higher than the A/D detection voltage value Vad) and means a voltage comparatively lower during discharging of the batteries (for example, a voltage value lower than the A/D detection voltage value Vad).

The charging and discharging control section 9 controls the charging and discharging of the batteries in the voltage source section 2 based on the detection results for overcharging states and excessive discharging stated according to the actual detection value Vout, digital circuit section 8, and the voltage level determination sections 16[i]. The charging and discharging control section 9 controls the charging and discharging section 5 such that charging of the batteries 2[i] by the charging circuit 4 is stopped when the batteries 2[i] are determined to be in an overcharging state during charging of the batteries 2[i] and such that discharging of the batteries 2[i] to the load 3 is stopped when the batteries 2[i] are determined to be in an excessive discharging state during discharging of the batteries 2[i]. Moreover, the stopping of the charging and discharging of the batteries 2[i] is implemented by, for example, opening a switch that is provided between the voltage source section 2 and the charging and discharging section 5 and not shown in the drawing. In addition, when the batteries 2[i] are determined to be in an overcharging state or an excessive discharging state, or when the occurrence of a failure (including in-range failures) is determined in the voltage detection section 10, an alarm notification may be made to users using a display section (not shown in the drawing) or a speaker (not shown in the drawing) connected to the battery system 1.

[Causes of in-range failures]

Before describing the operation of the digital circuit section 8 during occurrences of in-range failures, the causes of in-range failures will be considered. Moreover, in the following description, the output voltage for the batteries 2[i] may be called the battery voltage.

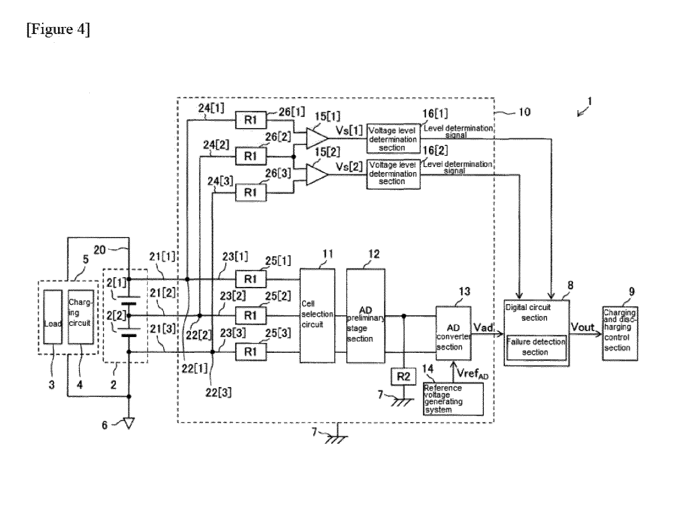

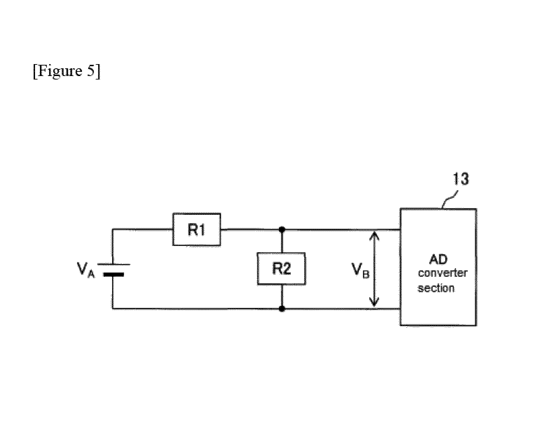

Figure 4 shows the circuit state for the battery system 1 when a leak current occurs because of a failure in a circuit on the A/D converter section 13 side and this leak current invites an in-range failure. Moreover, the resistance values for the current suppressing elements 25[i] and 26[i] are set as R1. The state in which a leak current occurs in the circuit on the A/D converter section 13 side can be viewed as state in which a resistance component of a resistance value R2 is inserted between the signal line (the signal line between the A/D preliminary stage section 12 and the A/D converter section 13 in the example in Figure 4) that transmits the analog voltage signal for the battery voltage and the reference potential point 7. When this resistance component is inserted, the battery voltage will be detected as the following $V_B$ by the A/D converter section 13 even if the true value for the battery voltage is $V_A$ (see Figure 5).

$$V_B = (R2/(R1 + R2)) \times V_A$$

$$= K \times V_A$$

Here $K = (R2/(R1+R2)) = V_B/V_A$, and K or 1/K represents the ratio of $V_A$ and $V_B$. To find the true value $V_A$ for the battery voltage, the $V_B$ obtained from the A/D converter section 13 is multiplied by the ratio 1/K.

When a leak current occurs in the circuit on the voltage level determination section 16[i] side, the same kind of considerations are possible.

In addition, in-range failures also occur because of the reference voltage VrefAD on the A/D converter section 13 side and the voltage value for either the base reference voltage VrefA or VrefB on the voltage level determination sections 16[i] side being offset from the design value.

Alternatively, some offset may be superimposed in the process of obtaining the A/D detection voltage value Vad and the level determination signal from the analog voltage signal for the battery voltage, and in-range failures also arise because of this superimposition.

In the following, several embodiments will be described with the constitution and operation of the battery system 1 described above as their basis. In the description of each embodiment, the descriptions above are to be used for any items that are not specifically described. In addition, items described in one embodiment may be used in another embodiment as long as there is no inconsistency.

«First Embodiment»

A first embodiment will be described. If there is no particular need in the following, the description will focus on one battery in the voltage source section 2 and describe a method in which the actual detection value Vout for the battery focused on is generated from the A/D detection voltage value Vad and the determination voltage value for the battery that is focused on. The same applies to other embodiments that will be described in the following. If the batteries in the voltage source section 2 are focused on individually and the following method for generating the actual detection value Vout is used, the actual detection value Vout for each battery in the voltage source section 2 can be generated. In the following description, a battery in the voltage source section 2 is indicated when "battery" alone is used.

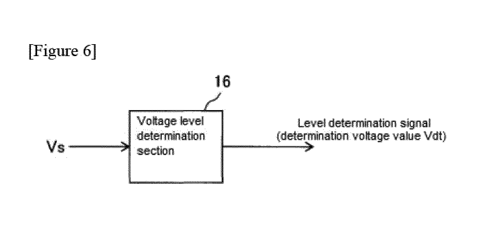

The output voltage for the buffer amplifier (15[1] or 15 [2]) for the battery being focused on is represented by Vs (see Figure 1 and Figure 6). Therefore, if the battery being focused on is the battery 2[1], Vs = Vs[1], and if the battery being focused on is the battery 2[2], Vs = Vs[2]. Furthermore, as is shown in Figure 6, the voltage level determination section (16[1] or 16[2]) for the battery being focused on is represented by the element number 16, and the determination voltage value shown with the level determination signal from the voltage level determination section 16 is denoted by Vdt. In addition, in the following descriptions, the A/D detection voltage value Vad may be abbreviated to voltage value Vad or Vad, and the determination voltage value Vdt may be abbreviated to voltage value Vdt or Vdt. The same applies to voltage Vs, actual detection value Vout, and the like.

1. First case: when Vad < Vdt

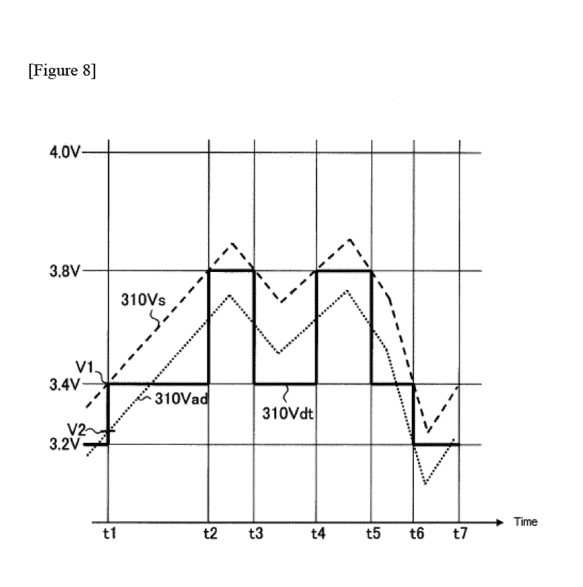

First of all, a case (called first case in the following) in which the A/D detection voltage value Vad in the change timing for the level determination signal is detected as lower than the determination voltage value Vdt because of an in-range failure will be considered. In Figure 8, the voltage waveforms for Vad, Vs, and Vdt in the first case are shown as dashed broken line 310Vad, dashed broken line 310Vs, and bold solid broken line 310Vdt, respectively. As time progresses, times t1, t2, t3, t4, t5, t6, and t7 are visited in this order. The change timing for the level determination signal indicates the timing that any of the signal values for the signals L11, L12, L 13, L 14, L21, L22, L23 and L24 that form the level determination signal changes, and the determination voltage value Vdt also changes with the change timing for the level determination signal. In the first case, the times t1, t2, t3, t4, t5 and t6 each correspond to a change timing for the level determination signal.

As causes for the A/D detection voltage value Vad at the change timing for the level determination signal being detected as lower than the determination voltage value Vdt, for example, the following causes $Y_{A1}$, $Y_{A2}$, and $Y_{A3}$ due to failures on the A/D converter section 13 side and the following causes $Y_{B1}$ and $Y_{B2}$ due to failures on the voltage level determination section 16 side can be considered.

The cause $Y_{A1}$ is a cause of failure in which the value for the reference voltage VrefAD is offset to the high voltage side of the design value.

The cause $Y_{A2}$ is a cause of failure in which a leak current occurs in the signal line transmitting the analog voltage signal for the battery voltage to the A/D converter section 13.

The cause $Y_{A3}$ is a cause of failure in which, in the process of generating the A/D detection voltage value Vad from the analog voltage signal for the battery voltage, a negative offset that goes toward the direction of reducing the A/D detection voltage value Vad is superimposed on the analog voltage signal for the battery voltage.

The cause $Y_{B1}$ is a cause of failure in which the reference voltage (VrefA and the like; see Figure 2) in the voltage level determination section 16 is offset to the low voltage side more than the design value.

The cause $Y_{B2}$ is a cause of failure in which, in the process of generating the level determination signal from the analog voltage signal for the battery voltage, a positive offset that goes toward the direction of increasing the determination voltage value Vdt is superimposed on the analog voltage signal for the battery voltage.

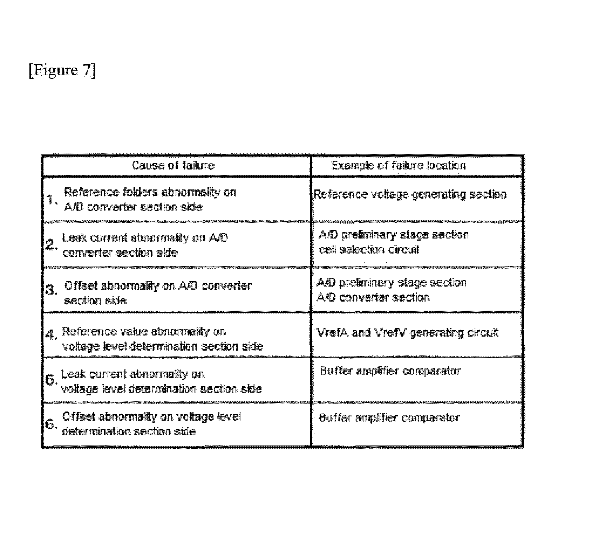

In Figure 7, an example showing causes of failure that invite in-range failures and the locations of the failures is shown. In Figure 7, first - sixth failure causes are shown as examples for causes of failures. The causes $Y_{A1}$, $Y_{A2}$,

$Y_{A3}$, $Y_{B1}$ and $Y_{B2}$ described above are one type of the first, second, third, fourth and sixth failure causes (one type of the fifth failure cause will be shown later).

The first failure cause is an abnormality in the reference voltage (in other words, VrefAD) on the A/D converter section side. The reference voltage generating section 14 can be cited as an example for the failure location corresponding to the first failure cause.

The second failure cause is a leak current abnormality on the A/D converter section side. The A/D preliminary stage section 12 and cell selection circuit 11 can be cited as examples for failure locations of the second failure cause. For example, when the current (in other words, leak current) taken into the A/D preliminary stage section 12 from the batteries 2[i] is abnormally large, an in-range failure occurs because of the second failure cause.

The third failure cause is an offset abnormality on the A/D converter section side. The A/D preliminary stage section 12 and A/D converter section 13 can be cited as examples for failure locations of the third failure cause. For example, when an abnormally large offset is superimposed on the analog voltage signal for the battery voltage input to the A/D converter section 13, an in-range failure occurs because of the third failure.

The fourth failure cause is an abnormality in the reference voltage (in other words, Vref[j]) on the voltage level determination section side. The circuit (not shown in the drawing) that generates the base reference voltage VrefA and VrefB in Figure 2 can be cited as an example of the failure location for the fourth failure cause.

The fifth failure cause is a leak current abnormality on the voltage level determination section side. The buffer amplifiers 15[i] and comparators CMP[j] can be cited as examples of failure locations for the fifth failure cause. For example, when the current (in other words, leak current) taken into the buffer amplifiers 15[i] from the batteries 2[i] is abnormally large, an in-range failure occurs because of the fifth failure cause.

The sixth failure cause is an offset abnormality on the voltage level determination section side. The buffer amplifiers 15[i] and comparators CMP[j] can be cited as examples of failure locations for the sixth failure cause. For example, when an abnormally large offset is superimposed on the analog voltage signal for the battery voltage input to the comparators CMP[j], an in-range failure occurs because of the sixth failure.

The abnormalities in each of the failure causes indicate states in which the error between the design value and actual value for a certain physical quantity (value for offset voltage and the like) is larger than a prescribed allowable amount.

In the first case, the voltage Vs was less than 3.4 V at a time before the time t1, but thereafter, the voltage Vs is set at 3.4 V and 3.8 V respectively for the times t1 and t2 because the voltage Vs rises until an intermediate time between the times t2 and t3. Furthermore, starting at an intermediate time between the times t2 and t3, the voltage Vs begins to fall, and just before the time t3, the voltage Vs, which had risen above 3.8 V, is set to go under 3.8 V at the time t3.

Therefore, the value for the output signal for the comparator CMP[4] in the voltage level determination section 16 switches from "0" to "1" at the time t1, and at the time t2, the value for the output signal for the comparator CMP[3] in the voltage level determination section 16 switches from "0" to "1"; at the time t3, the value for the output signal for the comparator CMP[3] in the voltage level determination section 16 switches from "1" to "0." Therefore, Vdt just before the time t1 is 3.2 V, and between the times t1 and t2, Vdt is 3.4 V; between the times t2 and t3, Vdt is 3.8 V, and just after the time t3, Vdt is 3.4 V. Thereafter, Vdt between the times t3 and t4, Vdt between the times t4 and t5, Vdt between the times t5 and t6, and Vdt between the times t6 and t7 are 3.4 V, 3.8 V, 3.4 V, and 3.2 V, respectively, because of the increases and decreases in the voltage Vs.

The digital circuit section 8 can detect the presence or absence of occurrences of in-range failures based on the A/D detection voltage value Vad and the determination voltage value Vdt at the change timing for the level determination signal. Now, the focus will be on time t1, and the determination voltage value Vdt at the time t1 is a voltage value V1 (= 3.4 V), and the A/D detection voltage value Vad at the time t1 is set as a voltage value V2. The digital circuit section 8 can determine that the A/D detection voltage value Vad is lower than the determination voltage value Vdt at the time t1, and according to this determination, can detect the occurrence of an in-range failure. The other times (t2, t3, t4, t5 and t6), when the level determination signal changes, are similar.

When the occurrence of an in-range failure is detected, the digital circuit section 8 can find Vout by correcting Vad as follows. This will be described separately for the current directions for the batteries and each cause of in-range failures.

I-1. During charging (Vad < Vdt)

During charging, the following processing is carried out in the first case in which the A/D detection voltage value Vad at the change timing for the level determination signal is detected as being lower than determination voltage value Vdt.

I-1-1.

First of all, cases of a failure on the A/D converter section 13 side are considered.

For cause $Y_{A3}$ that concerns offset superimposition, unlike the example in Figure 5, simply correcting Vad with a ratio ($V_B/V_A$ in Figure 5) is difficult, but Vout can be set on the safe side by doing the following. When the cause $Y_{A3}$ is the cause of an in-range failure V2 = V1-$\alpha$.

Here, $\alpha$ is the size of the offset for the cause $Y_{A3}$ ($\alpha$ > 0).

V1/V2 = V1/(V1 - $\alpha$) represents the ratio of Vad and Vdt at the time t1; therefore, Vout can be found according to "Vout = Vad · V1/(V1 - $\alpha$)." However, when the cause $Y_{A3}$ is the cause of an in-range failure, Vout being greater than or equal to the true value for the battery voltage (Vad + $\alpha$) is vital for safety, but Vout according to "Vout = Vad · V1/(V1 - $\alpha$)" does not satisfy this requirement.

Therefore, a method (called first correction method in the following) of outputting the larger of voltage values Va and Vb according to the following equations (1a) and (1b) as Vout can be used. The first correction method may also be read is the first estimation method for estimating Vout (same for the second through fourth correction methods that will be described in the following).

$$Va = Vad \;\cdot\; V1/(V1 - \alpha) = Vad \;\cdot\; V1/V2 \;\ldots\; (1a)$$

$$Vb = Vad + \alpha = Vad + (V1 - V2) \;\ldots\; (1b)$$

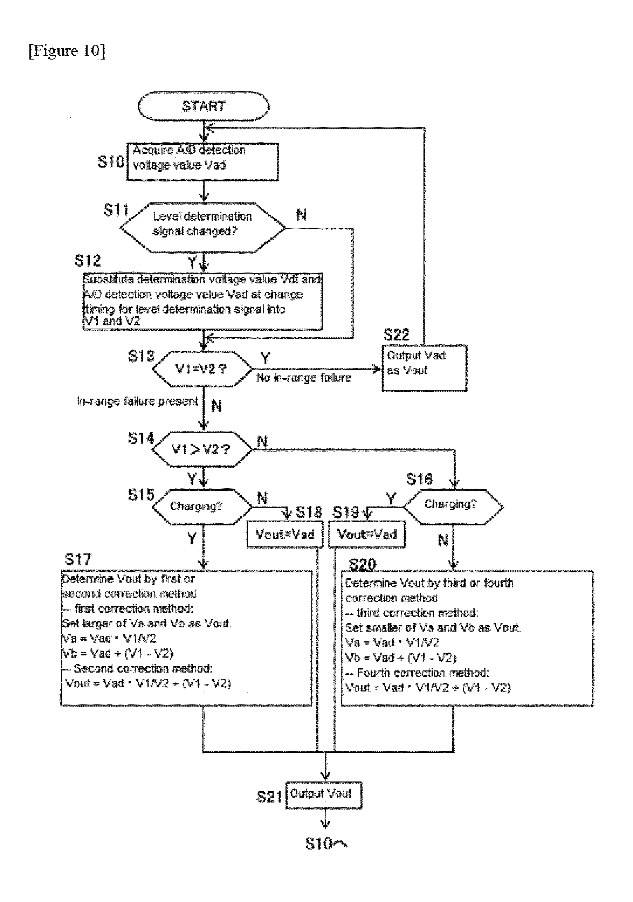

Alternatively, a method (called second correction method in the following) of finding Vout according to the following equation (2) may be used. Generation of Vout by the first or second correction method corresponds to the processing in step S 17 in Figure 10, which will be described in the following.

$$\begin{aligned} Vout &= Vad \;\cdot\; V1/(V1 - \alpha) + \alpha \\ &= Vad \;\cdot\; V1/V2 + \alpha \\ &= Vad \;\cdot\; V1/V2 + (V1 - V2) \;\ldots\; (2) \end{aligned}$$

When the cause $Y_{A1}$ or $Y_{A2}$ is the cause of an in-range failure, Vout, which is obtained by multiplying the ratio (V1/V2) by Vad, Vout matches the true value for the battery voltage as in Figure 5. Therefore, by using the first or second correction method described above, a voltage value on the safe side can be generated for Vout (in other words, Vout is greater than or equal to a true value for the battery voltage)

I-1-2.

Next, the case of there being a failure on the voltage level determination section 16 side will be considered. When the cause $Y_{B1}$ or $Y_{B2}$ is the cause of an in-range failure, Vad is the true value for the battery voltage; therefore, if a voltage value equal to or greater than the product of Vad multiplied by the ratio (V1/V2) is found for Vout, Vout will be a voltage value on the safe side. Therefore, even when the cause $Y_{B1}$ or $Y_{B2}$ is the cause of an in-range failure, a voltage value on the safe side for charging can be found for Vout.

Methods for generating Vout for each cause of in-range failures have been described, but, in the end, the correction method (in other words, method for generating Vout) for Vad used during charging for the first case is used in common, regardless of the cause of the in-range failure. Therefore, the cause of the in-range failure does not need to be detected for finding Vout.

The first or second correction method that uses Vdt and Vad at the time t1 for V1 and V2 is used up to the timing at which the level determination signal changes next (in other words, the time t2). In other words, in addition to using Vdt and Vad at the time t1 for V1 and V2, respectively, Vad at any time between the time t1 and t2 is corrected by the first or second correction method and Vout is generated. Therefore, if provisionally, Va in equation (1a) above in the case where the cause of an in-range failure is $Y_{A1}$, continually generates Vout, the voltage waveform for Vout matches the voltage waveform 310Vs between the times t1 and t2. The first and second correction methods, which use Vdt and Vad at the time t1 for V1 and V2, may further be used at the time t2 or thereafter.

I-2. During discharging (Vad < Vdt)

During discharging excessive discharging becomes a problem. Therefore, in the first case, Vad, which is a comparatively small value, is used for Vout during the discharging with expectations of safety (corresponding to step S18 in Figure 10, which will be described in the following). Thus, occurrences of excessive discharging can be safely avoided.

II. Second case: when Vad > Vdt

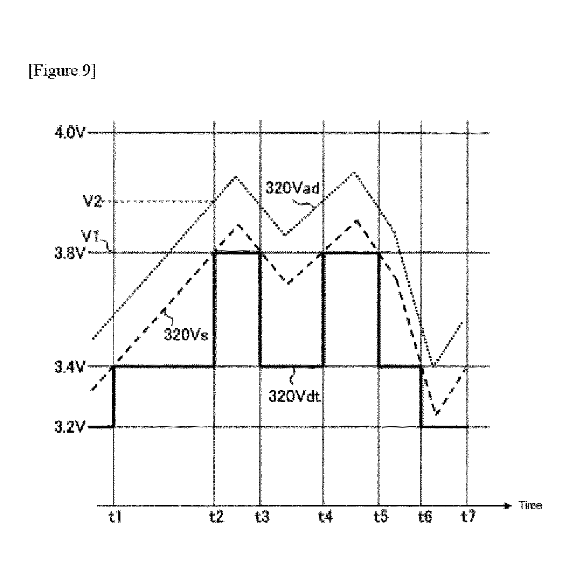

Next, a case (called second case in the following) in which the A/D detection voltage value Vad in the change timing for the level determination signal is detected as higher than the determination voltage value Vdt because of an in-range failure will be considered. In Figure 9, the voltage waveforms for Vad, Vs, and Vdt in the second case are shown as dashed broken line 320Vad, dashed broken line 320Vs, and bold solid broken line 320Vdt, respectively. The voltage waveforms 320Vs and 320Vdt for Vs and Vdt in the second case are the same as the voltage waveforms 310Vs and 31Vdt for Vs and Vdt (see Figure 9) in the first case. Therefore, the determination voltage values Vdt at various times are the same in the first and second cases.

As causes for the A/D detection voltage value Vad at the change timing for the level determination signal being detected as higher than the determination voltage value Vdt, for example, the following causes $Y_{C1}$ and $Y_{C2}$ due to failures on the A/D converter section 13 side and the following causes $Y_{D1}$, $Y_{D2}$, and $Y_{D3}$ due to failures on the voltage level determination section 16 side can be considered.

The cause $Y_{C1}$ is a cause of failure in which the value for the reference voltage VrefAD is offset to the low voltage side of the design value.

The cause $Y_{C2}$ is a cause of failure in which a positive offset in the direction of increasing the A/D detection voltage value Vad in the process of generating the A/D detection voltage value Vad from the analog voltage signal for the battery voltage is superimposed on the analog voltage signal for the battery voltage.

The cause $Y_{D1}$ is a cause of failure in which the reference voltage (VrefA and the like; see Figure 2) in the voltage level determination section 16 is offset to the high voltage side more than the design value.

The cause $Y_{D2}$ is a cause of failure in which a leak current is generated in the signal line that transmits the analog voltage signal for the battery voltage to the voltage level determination section 16.

The cause $Y_{D3}$ is a cause of failure in which a negative offset toward the direction of reducing the determination voltage value Vdt in the process of generating the level determination signal from the analog voltage signal for the battery voltage is superimposed on the analog voltage signal for the battery voltage. The causes $Y_{C1}$, $Y_{C2}$, $Y_{D1}$, $Y_{D2}$, and $Y_{D3}$ are one type of the first, third, fourth, fifth, and sixth failure causes, respectively, shown in Figure 7.

The digital circuit section 8 can detect the presence or absence of occurrences of in-range failures based on the A/D detection voltage value Vad and the determination voltage value Vdt at the change timing for the level determination signal. As in the first case, in the second case, the times t1, t2, t3, t4, t5, and t6 each correspond to a change timing for the level determination signal. Now, the focus will be on the time t2, and the determination voltage value Vdt at the time t2 is a voltage value V (=3.8 V), and the A/D detection voltage value Vad at the time t2 is set as a voltage value V2. The digital circuit section 8 can determine that the A/D detection voltage value Vad is higher than the determination voltage value Vdt at the time t2, and according to this determination, can detect the occurrence of an in-range failure. The other times (t1, t3, t4, t5, and t6) when the level determination signal changes are similar.

When the occurrence of an in-range failure is detected, the digital circuit section 8 can find Vout by correcting Vad as follows. This will be described separately for the current directions for the batteries and each cause of in-range failures.

I-1. During charging (Vad > Vdt)

During charging overcharging becomes a problem. Therefore, in the second case, Vad, which is a comparatively large value, is used for Vout during the charging with expectations of safety (corresponding to step S 19 in Figure 10, which will be described in the following). Thus, occurrences of overcharging can be safely avoided.

I-2. During discharging (Vad > Vdt)

In the second case, processing is carried out as follows during discharging.

II-2-1.

First of all, the case of there being a failure on the voltage level determination section 16 side will be considered.

For cause $Y_{D3}$ that concerns offset superimposition, unlike the example in Figure 5, simply correcting Vad with a ratio ($V_B/V_A$ in Figure 5) is difficult, but Vout can be set on the safe side by doing the following. When the cause $Y_{D3}$ is the cause of an in-range failure V2 = V1 + $\alpha$.

Here, $\alpha$ is the size of the offset for the cause $Y_{D3}$ ($\alpha > 0$). $V1/V2 = V1/(V1 + \alpha)$ represents the ratio of Vad and Vdt at the time t2; therefore, Vout can be found according to "Vout = Vad · V1/(V1 + $\alpha$)." However, when the cause $Y_{D3}$ is the cause of an in-range failure, Vout being less than or equal (Vad + $\alpha$) is vital for safety, but Vout according to "Vout = Vad · V1/(V1 - $\alpha$)" does not satisfy this requirement.

Therefore, a method (called third correction method in the following) of outputting the smaller of voltage values Va and Vb according to the following equations (3a) and (3b) as Vout can be used.

$$Va = Vad \cdot V1/(V1 + \alpha) = Vad \cdot V1/V2 \ldots (3a) \quad Vb = Vad - \alpha = Vad + (V1 - V2) \ldots (3b)$$

Alternatively, a method (called fourth correction method in the following) of finding Vout according to the following equation (4) may be used. Generation of Vout by the third or fourth correction method corresponds to the processing in step S20 in Figure 10, which will be described in the following.

$$\begin{aligned} Vout &= Vad \cdot V1/(V1 + \alpha) - \alpha \\ &= Vad \cdot V1/V2 - \alpha \\ &= Vad \cdot V1/V2 + (V1 - V2) \ldots (4) \end{aligned}$$

When the cause $Y_{D1}$ or $Y_{D2}$ is the cause of an in-range failure, Vout, which is obtained by multiplying the ratio (V1/V2) by Vad, Vout matches the true value for the battery voltage as in Figure 5. Therefore, by using the third or fourth correction method described above, a voltage value on the safe side can be generated for Vout (in other words, Vout is less than or equal to a true value for the battery voltage).

II-2-2.

Next, cases of a failure on the A/D converter section 13 side are considered.

For cause $Y_{C2}$ that concerns offset superimposition, unlike the example in Figure 5, simply correcting Vad with a ratio ($V_B/V_A$ in Figure 5) is difficult, but Vout can be set on the safe side by doing the following. When the cause $Y_{C2}$ is the cause of an in-range failure V2 = V1 + $\alpha$.

Here, $\alpha$ is the size of the offset for the cause $Y_{C2}$ ($\alpha > 0$). Here the relational equation "V2 = V1 + $\alpha$" is the same as that when the cause $Y_{D3}$ is the cause of an in-range failure. Therefore, when the cause $Y_{C2}$ is the cause of an in-range failure, a voltage value on the safe side can be generated as Vout by the third and fourth estimation methods.

When the cause $Y_{C1}$ is the cause of an in-range failure, Vout, which is obtained by multiplying the ratio (V1/V2) by Vad, Vout matches the true value for the battery voltage as in Figure 5. Therefore, by using the third or fourth correction method described above, a voltage value on the safe side can be generated for Vout (in other words, Vout is less than or equal to a true value for the battery voltage).

Methods for generating Vout for each cause of in-range failures have been described, but, in the end, the correction method (in other words, method for generating Vout) for Vad used during discharging for the second case is used in common, regardless of the cause of the in-range failure. Therefore, the cause of the in-range failure does not need to be detected for finding Vout.

The third or fourth correction method that uses Vdt and Vad at the time t2 for V1 and V2 is used up to the timing at which the level determination signal changes next (in other words, the time t3). In other words, in addition to using Vdt and Vad at the time t2 for V1 and V2, respectively, Vad at any time between the time t2 and t3 is corrected by the third or fourth correction method and Vout is generated. The third and fourth correction methods, which use Vdt and Vad at the time t2 for V1 and V2, may further be used at the time t3 and thereafter.

-- Flowchart of operation --

Next, the operating procedure for the battery system 1 will be described with reference to Figure 10 and with particular focus on the process for generating Vout. Figure 10 is a flowchart representing this operating procedure.

First of all, in step S10, the A/D detection voltage value Vad is acquired from the A/D converter section 13. The acquisition process for Vad in step S10 is executed periodically at a prescribed sampling period. In step S11, which follows step S10, the digital circuit section 8 confirms whether or not the level determination signal has changed. When a change to the level determination signal is confirmed, the processing in step S 13 is executed after the processing in step S12 is executed, but when no change to the level determination signal is confirmed, the processing in step S 13 is executed without executing the processing in step S12. In the example in Figure 8 or Figure 9, changes to the level determination signal are confirmed at each of times t1, t2, t3, t4, t5, and t6.

In step S12, the digital circuit section 8 substitutes the determination voltage value Vdt (more accurately, the determination voltage value Vdt represented by the level determination signal after the change) in the timing in which the level determination signal is changed for the voltage value V1 and substitutes the A/D detection voltage value Vad at the timing of when the level determination signal is changed for the voltage value V2. Moreover, in the operations in Figure 10, V1 and V2 are handled as variables, and the initial values for V1 and V2 are the same.

In step S13, the digital circuit section 8 determines whether or not the voltage values V1 and the voltage value V2 match, and when the determination is that the voltage values V1 and the voltage value V2 match (Y in step S 13), a determination is made that no in-range failure has occurred; in step S22, the most recent Vad itself is output to the charging and discharging control section 9 (Figure 1) as Vout. Thereafter, the processing returns to step S10. On the other hand, when a determination is made that the voltage value V1 and the voltage value V2 do not match (N in step S 13), a determination is made that an in-range failure has occurred, and the processing in step S 14 is executed after step S 13. Moreover, the matching of the voltage values V1 and V2 can be interpreted as a concept having a certain degree of breadth. For example, if the difference (V1 - V2) between the voltage values V1 and V2 is less than a certain determination threshold value $V_{TH}$ for in-range failure, the voltage values V1 and V2 may be determined to be matching, and if the difference (V1 - V2) is greater than or equal to the determination threshold value $V_{TH}$, the voltage values V1 and V2 may be determined as not matching ($V_{TH} > 0$). The same applies to other embodiments that will be described in the following.

In step S14 and step S15 or S16, which is executed after step S14, the digital circuit section 8 compares the voltages V1 and V2 and confirms whether the batteries are being charged or being discharged. The digital circuit section 8 can confirm whether the batteries are being charged or discharged based on the detection results of a current sensor (not shown in the drawings) that detects the output current of the batteries. Furthermore, when V1 > V2 and the batteries are being charged, Vout is determined in step S 17, and when V1 > V2 and the batteries are being discharged, Vout is determined in step S 18. When V1 < V2 and the batteries are being charged, Vout is determined in step S 19, and when V1 < V2 and the batteries are being discharged, Vout is determined in step 20.

In step S17, Vout is determined by the first correction method described above. Alternatively, Vout may be determined by the second correction method described above. When the first correction method is used in step S 17, Va and Vb are calculated based on the equations (1a) and (1b) above using the most recent Vad acquired in step S10 and V1 and V2 set in step S12, and the larger of the voltage values Va and Vb is determined for Vout. When the second correction method is used in step S 17, the voltage value Vout is determined based on the equation (2) above using the most recent Vad acquired in step S10 and V1 and V2 set in step S12.

Step S18 and S19 each set the most recent Vad acquired in step S10 as is for Vout.

In Step S20, Vout is determined by the third correction method described above. Alternatively, Vout may be determined by the fourth correction method described above. When the third correction method is used in step S20, Va and Vb are calculated based on the equations (3a) and (3b) above using the most recent Vad acquired in step S10 and V1 and V2 set in step S12, and the smaller of the voltage values Va and Vb is determined for Vout. When the fourth correction method is used in Step S20, the voltage value Vout is determined based on the equation (4) above using the most recent Vad acquired in step S10 and V1 and V2 set in step S12.

Vout determined in steps S17, S 18, S19, and S20 is output from the digital circuit section 8 to the charging and discharging control section 9 in step S21, and thereafter, the processing returns to step S10.

As described above, the determination voltage value Vdt and A/D detection voltage value Vad corresponding to the timing in which the level determination signal changes are set as V1 and V2, and the presence or absence of in-range failures is detected by comparing V1 and V2 (step S12 and S 13). Furthermore, when an occurrence of an in-range failure is detected at the first time (for example time, t1 in Figure 8), Vout at the second time is determined (steps S14 - S20) based on the determination voltage value Vdt and A/D detection voltage value Vad at the first time (in other words, V1 and V2 in step S12) and the A/D detection voltage value Vad at the second time (for example, Vad at any time between the times t1 and t2 in Figure 8) while considering whether the batteries are being charged or being discharged. The second time is the first time or any time after the first time.

In this instance, if an occurrence of an in-range failure is detected at the first time and "V1 > V2" when the batteries are charging, Vout is determined (step S 17) at the second time by a correction that increases the A/D detection voltage value Vad at the second time, based on at least one of the ratio of the voltage values V1 and V2 (V1/V2) and the difference (V1 - V2) of the voltage values V1 and V2. Thus, a voltage value on the safe side for overcharging is set for Vout; therefore, when an in-range failure occurs, the batteries can be charged safely. Conversely, even when the batteries are charging, occurrences of overcharging can be safely avoided by simply setting Vout = Vad (step S 19) if "V1 < V2."

In addition, when the batteries are discharging, Vout is determined (step S20) at the second time by making a correction that reduces the A/D detection voltage value Vad at the second time, based on at least one of the ratio (V1/V2) described above and the difference (V1 - V2) described above if an occurrence of an in-range failure is detected at the first time and "V1 < V2." Thus, a voltage value on the safe side for excessive discharging is set for Vout; therefore, when an in-range failure occurs, the batteries can be discharged safely. Conversely, even when the batteries are discharging, occurrences of excessive discharging can be safely avoided by simply setting Vout = Vad (step S 18) if "V1 < V2."

«Second Embodiment»

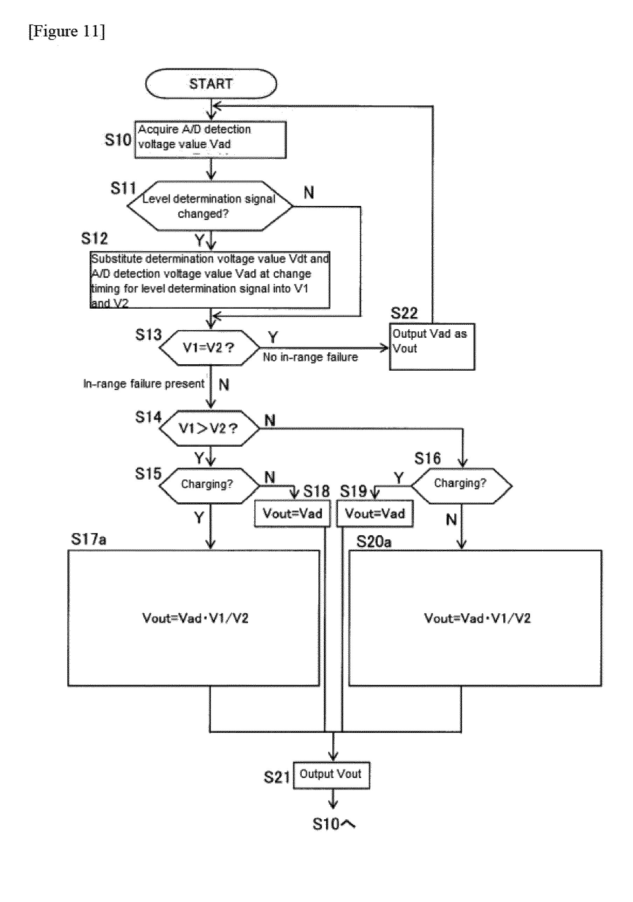

A second embodiment will be described. The second embodiment is an embodiment that modifies part of the first embodiment. Only the parts different from the first embodiment will be described. Figure 11 is a flowchart for a battery system 1 according to the second embodiment and with particular focus on the process for generating Vout. The flowchart in Figure 11 replaces steps S 17 and S20 in the flowchart in Figure 10 with steps S 17a and S20a, respectively, and the processing in the various steps other than these is the same in the flowcharts is Figure 10 and Figure 11.

As with step S 17 in Figure 10, step 17a is executed when V1 > V2 and the batteries are being charged. In step 17a, the digital circuit section 8 determines Vout according to the equation "Vout = Vad • V1/V2" using the most recent Vad acquired in step S10 and V1 and V2 set in step S12. When V1 > V2, step S 17a is executed; therefore, as with step S 17 in Figure 10, Vout is determined by making a correction that increases the A/D detection voltage value Vad. Thus, as with the first embodiment, a voltage value on the safe side for overcharging is set for Vout, and when an in-range failure occurs, the batteries can be charged safely. However, as in the first embodiment, determining Vout with consideration given to the difference (V1 - V2) increases the safety more.

As with step S20 in Figure 10, step 20a is executed when V1 < V2 and the batteries are being discharged. In step 20a, the digital circuit section 8 determines Vout according to the equation "Vout = Vad • V1/V2" using the most recent Vad acquired in step S10 and V1 and V2 set in step S12. When V1 < V2, step S20a is executed; therefore, as with step S20 in Figure 10, Vout is determined by making a correction that decreases the A/D detection voltage value Vad. Thus, as with the first embodiment, a voltage value on the safe side for excessive discharging is set for Vout, and when an in-range failure occurs, the batteries can be discharged safely. However, as in the first embodiment, determining Vout with consideration given to the difference (V1 - V2) increases the safety more.

«Third Embodiment»

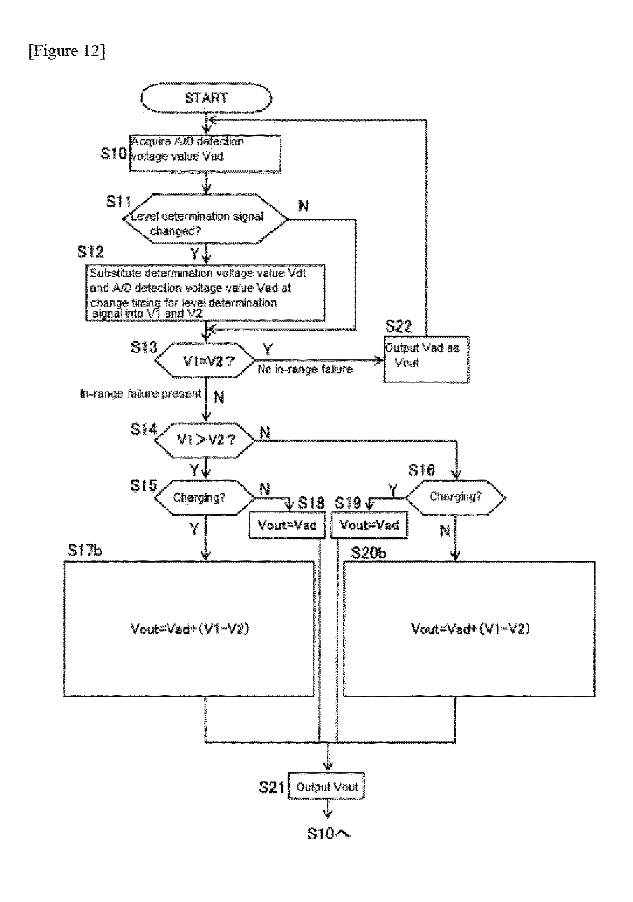

A third embodiment will be described. The third embodiment is an embodiment that modifies part of the first embodiment. Only the parts different from the first embodiment will be described. Figure 12 is a flowchart for a battery system 1 according to the third embodiment and with particular focus on the process for generating Vout. The flowchart in Figure 12 replaces steps S 17 and S20 in the flowchart in Figure 10 with S 17b and S20b, respectively, and the processing in the various steps other than these is the same in the flowcharts in Figure 10 and Figure 12.

As with step S17 in Figure 10, step 17b is executed when V1 > V2 and the batteries are being charged. In step 17b, the digital circuit section 8 determines Vout according to the equation "Vout = Vad + (V1 - V2)" using the most recent Vad acquired in step S10 and V1 and V2 set in step S12. When V1 > V2, step S 17b is executed; therefore, as with step S 17 in Figure 10, Vout is determined by making a correction that increases the A/D detection voltage value Vad. Thus, as with the first embodiment, a voltage value on the safe side for overcharging is set for Vout, and when an in-range failure occurs, the batteries can be charged safely. However, as in the first embodiment, determining Vout with consideration given to the ratio (V1/V2) increases the safety more.

As with step S20 in Figure 10, step 20b is executed when V1 < V2 and the batteries are being discharged. In step 20b, the digital circuit section 8 determines Vout according to the equation "Vout = Vad + (V1 - V2)" using the most recent Vad acquired in step S10 and V1 and V2 set in step S12. When V1 < V2, step S20a is executed; therefore, as with step S20 in Figure 10, Vout is determined by making a correction that decreases the A/D detection voltage value Vad. Thus, as with the first embodiment, a voltage value on the safe side for excessive discharging is set for Vout, and when an in-range failure occurs, the batteries can be discharged safely. However, as in the first embodiment, determining Vout with consideration given to the ratio (V1/V2) increases the safety more.

«Fourth Embodiment»

A fourth embodiment will be described. The method for determining Vout in the fourth embodiment when an in-range failure occurs will be described while dividing cases by the current direction for the batteries and the size relationship of Vad and Vdt. In the following description, Vdt, Vad and Vout at a time t will be denoted, in particular, as Vdt(t), Vad(t) and Vout(t), as necessary.

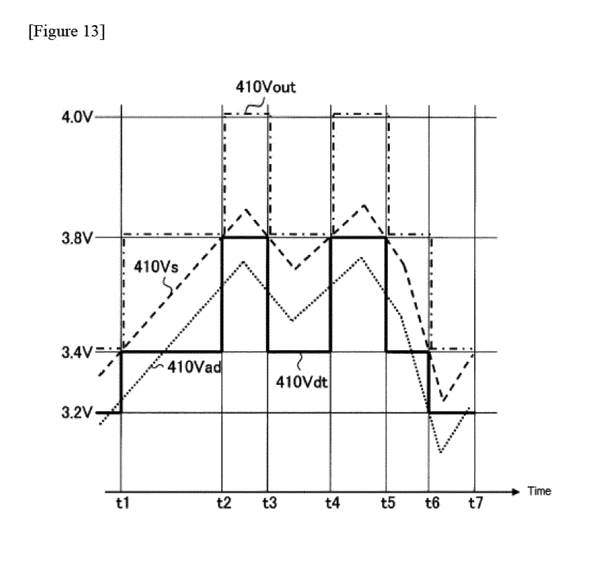

--Case A: When charging and when Vad < Vdt-- When the batteries are charging, a case (called case A in the following) in which the A/D detection voltage value Vad in the change timing for the level determination signal is detected as lower than the determination voltage value Vdt because of an in-range failure will be considered. In Figure 13, the voltage waveforms for Vad, Vs, and Vdt in the case A are shown as dashed broken line 410Vad, dashed broken line 410Vs, and bold solid broken line 410Vdt, respectively. The voltage waveforms 410Vad, 410Vs and 410Vdt in Figure 13 are the same as the voltage waveforms 310Vad, 310Vs and 310Vdt, respectively, in Figure 8. Therefore, the determination voltage value Vdt at each time is the same as that in the first case described above corresponding to Figure 8. In Figure 13, furthermore, a voltage waveform example for Vout in case A is shown by the dashed broken line 410Vout. Moreover, the waveform 410Vout is shown somewhat offset from its true position for convenience of the display in the Figure.

There is a necessity for being careful of overcharging during charging; therefore, when an in-range failure is detected, the digital circuit section 8 generates a voltage value (voltage value for comparison) $Vdt_{UP}$ by making a correction that increases Vdt. According to necessity, $Vdt_{UP}$ at time t is denoted as $Vdt_{UP}(t)$.

$Vdt_{UP}(t)$ is a reference voltage for which the voltage value is one stage higher than the reference voltage corresponding to Vdt(t). In other words, for example, if Vdt(t) = Vref(i), the reference value in which the voltage value is just one stage higher than the reference voltage corresponding to Vdt(t) is Vref(i-1) (see Figure 2). More specifically, for example, in the example in Figure 13, Vdt(t) between the times t1 and t2, between the times t2 and t3, between the times t3 and t4, between the times t4 and t5, between the times t5 and t6 and between the times t6 and t7 is 3.4 V, 3.8 V, 3.4 V, 3.8 V, 3.4 V and 3.2 V, respectively; therefore, $Vdt_{UP}(t)$ between the times t1 and t2, between the times t2 and t3, between the times t3 and t4, between the times t4 and t5, between the times t5 and t6 and between the times t6 and t7 is 3.8 V, 4.0 V, 3.8 V, 4.0 V, 3.8 V and 3.4 V respectively. Moreover, when the signal value for the comparator CMP [1] in Figure 2 is "1," the "reference value in which the voltage value is just one stage higher than the reference voltage corresponding to Vdt(t)" does not exist; therefore, $Vdt_{UP}(t)$ cannot be generated. However, in this case, the batteries are determined to be in a state of overcharging, and processing preventing charging of the batteries takes place; therefore, generation of $Vdt_{UP}(t)$ is unnecessary. In addition, a reference voltage with a voltage value that is several stages higher than the reference voltage corresponding to Vdt(t) may be set for $Vdt_{UP}(t)$. In other words, for example, when Vdt(t) = Vref(i), $Vdt_{UP}(t)$ = Vref(i-io) may be set (io being an integer of 2 or greater).

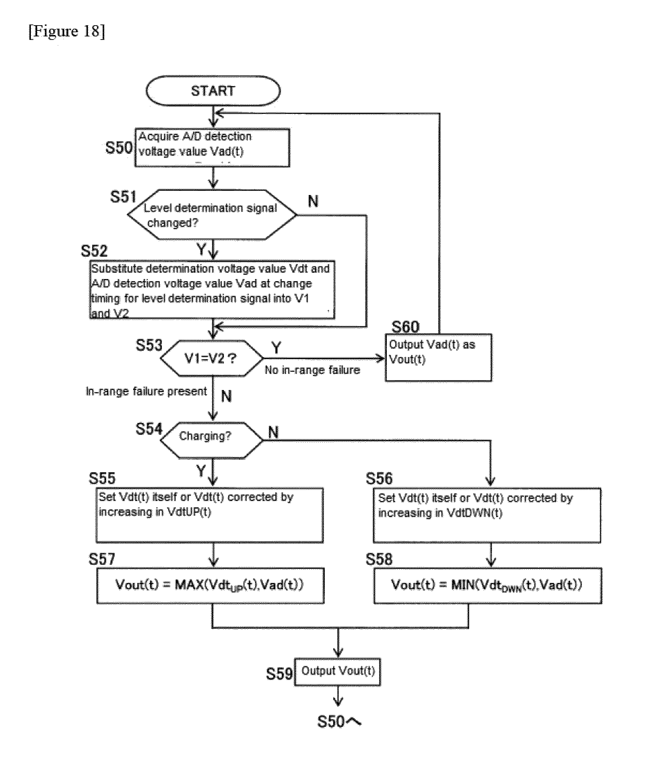

After finding $Vdt_{UP}(t)$, the digital circuit section 8 outputs the larger of $Vdt_{UP}(t)$ and Vad(t) as Vout(t) (corresponding to step S57 in Figure 18, which will be described in the following). In the example in Figure 13, Vad(t) < $Vdt_{UP}$ normally holds; therefore, $Vdt_{UP}(t)$ is normally selected as Vout(t), and the voltage waveform 410Vout, which matches the voltage waveform for $Vdt_{UP}(t)$ is obtained.

In other words, Vout(t) between the times t1 and t2, between the times t2 and t3, between the times t3 and t4, between the times t4 and t5, between the times t5 and t6 and between the times t6 and t7 is 3.8 V, 4.0 V, 3.8 V, 4.0 V, 3.8 V, and 3.4 V, respectively.

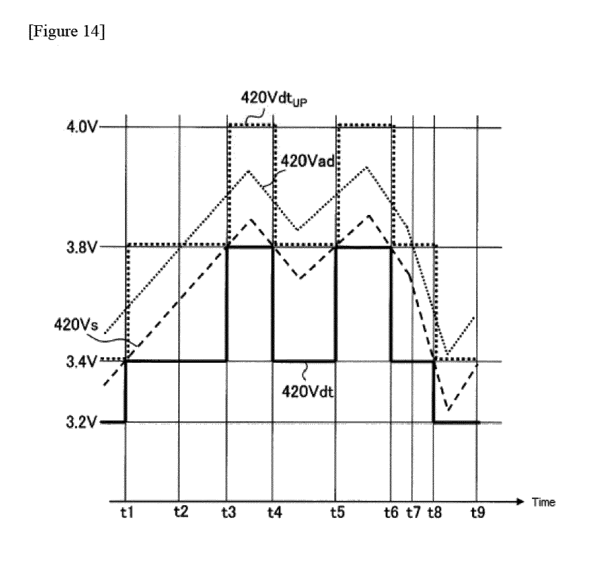

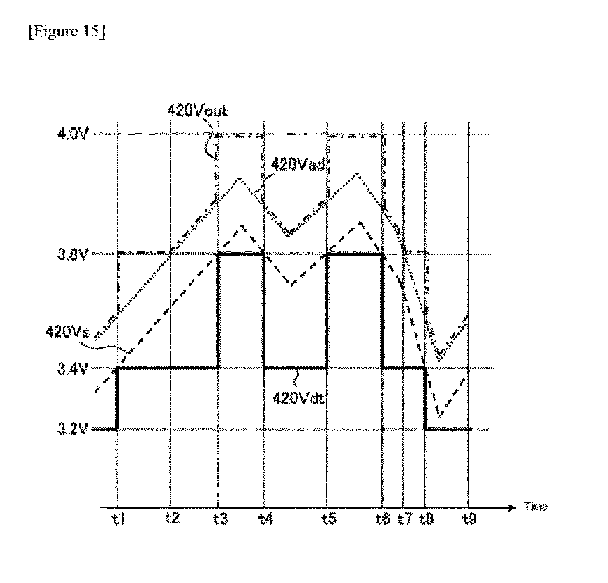

--Case B: When charging and when Vad > Vdt-- When the batteries are charging, a case (called case B in the following) in which the A/D detection voltage value Vad in the change timing for the level determination signal is detected as higher than the determination voltage value Vdt because of an in-range failure will be considered. In Figure 14 and Figure 15, the voltage waveforms for Vad, Vs, and Vdt in the case B are shown as dashed broken line 420Vad, dashed broken line 420Vs, and bold solid broken line 420Vdt, respectively. In Figure 14, furthermore, the voltage waveform example for $Vdt_{UP}$ in case B is shown by the dashed broken line 420$Vdt_{UP}$. In Figure 15, furthermore, a voltage waveform example for Vout in case B is shown by the dashed broken line 420Vout. Moreover, in Figure 14 and Figure 15, the voltage waveforms 420$Vdt_{UP}$ and 420Vout are shown somewhat offset from their true positions for convenience of the display in the Figure. As time progresses, times t1, t2, t3, t4, t5, t6, t7, t8 and t9 are visited in this order.

There is a necessity for being careful of overcharging during charging; therefore, when an in-range failure is detected, the digital circuit section 8 generates the voltage value $Vdt_{UP}$ by making a correction that increases Vdt. The method for generating $Vdt_{UP}$ is as described previously. Furthermore, as in case A, the digital circuit section 8 outputs the larger of $Vdt_{UP}(t)$ and Vad(t) as Vout(t) (corresponding to step S57 in Figure 18, which will be described in the following).

In the examples in Figure 14 and Figure 15, Vdt(t) between the times t1 and t2, between the times t2 and t3, between the times t3 and t4, between the times t4 and t5, between the times t5 and t6, between the times t6 and t7, between the times t7 and t8 and between the times t8 and t9 is 3.4 V, 3.4 V, 3.8 V, 3.4 V, 3.8 V, 3.4 V, 3.4 V and 3.2 V, respectively; therefore, $Vdt_{UP}(t)$ between the times t1 and t2, between the times t2 and t3, between the times t3 and t4, between the times t4 and t5, between the times t5 and t6, between the times t6 and t7, between the times t7 and t8 and between the times t8 and t9 is 3.8 V, 3.8 V, 4.0 V, 3.8 V, 4.0 V, 3.8 V, 3.8 V and 3.4 V, respectively.

On the other hand, in the examples in Figure 14 and Figure 15, $Vdt_{UP}(t)$ > Vad(t) holds between the times t1 and t2, between the times t3 and t4, between the times t5 and t6 and between the times t7 and t8, but between the times t2 and t3, between the times t4 and t5, between the times t6 and t7 and between the times t8 and t9, $Vdt_{UP}(t)$ < Vad(t) holds. Therefore, Vout between the times t1 and t2, between the times t3 and t4, between the times t5 and t6 and between the times t7 and t8 is 3.8 V, 4.0 V, 4.0 V and 3.8 V, respectively, and between the times t2 and t3, between the times t 4 and t5, between the times t6 and t7 and between the times t8 and t9, Vad(t) is Vout(t).

Moreover, in cases A and B, the setting of a reference voltage for $Vdt_{UP}(t)$ in which a voltage value that is one or a plurality of stages higher than the reference value corresponding to $Vdt(t)$ has been described, but $Vdt_{UP}(t)$ may be set by a method other than this. For example, $Vdt_{UP}(t)$ may be set according to "$Vdt_{UP}(t) = Vdt(t) + \Delta V$." Here, $\Delta V$ is a correction quantity having a prescribed value. A positive value can be set for $\Delta V$. The setting of a positive value for $\Delta V$ is preferable for preventing overcharging, but $\Delta V$ may be made zero. When $\Delta V$ is zero, $Vdt_{UP}(t)$ becomes $Vdt(t)$ itself (see step S55 in Figure 18, which will be described in the following).

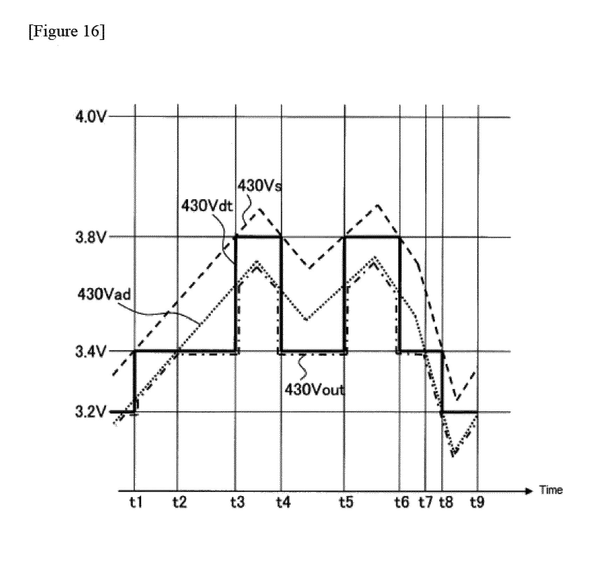

--Case C: When discharging and when Vad < Vdt-- When the batteries are discharging, a case (called case C in the following) in which the A/D detection voltage value Vad in the change timing for the level determination signal is detected as lower than the determination voltage value Vdt because of an in-range failure will be considered. In Figure 16, the voltage waveforms for Vad, Vs, and Vdt in the case C are shown as dashed broken line 430Vad, dashed broken line 430Vs, and bold solid broken line 430Vdt, respectively. In Figure 16, furthermore, a voltage waveform example for Vout in case C is shown by the dashed broken line 430Vout. Moreover, the waveform 430Vout is shown somewhat offset from its true position for convenience of the display in the Figure.

There is a necessity for being careful of excessive discharging during discharging. Therefore, when an in-range failure is detected, the digital circuit section 8 can generate a voltage value (voltage value for comparison) $Vdt_{DWN}$ that makes a correction that reduces Vdt. However, Vdt itself may be used for $Vdt_{DWN}$. In the example in Figure 16, the use of Vdt itself for $Vdt_{DWN}$ is envisioned. Moreover, according to necessity, $Vdt_{DWN}$ at time t is also denoted as $Vdt_{DWN}(t)$.

The digital circuit section 8 outputs the smaller of $Vdt_{DWN}(t)$ and Vad(t) as Vout(t) (corresponding to step S58 in Figure 18, which will be described in the following).

In the example in Figure 16, Vdt(t) between the times t1 and t3 is 3.4 V. Furthermore, $Vdt_{DWN}(t) > Vad(t)$ holds between the times t1 and t2; therefore, Vad(t) is output as Vout(t).

On the other hand, between the times t2 and t3, $Vdt_{DWN}(t) < Vad(t)$ holds. Therefore, between the times t2 and t3, $Vdt_{DWN}(t)$ between the times t2 and t3, that is 3.4 V is output as Vout(t). The same holds for times other than the times between t1 and t3.

--Case D: When discharging and when Vad > Vdt--

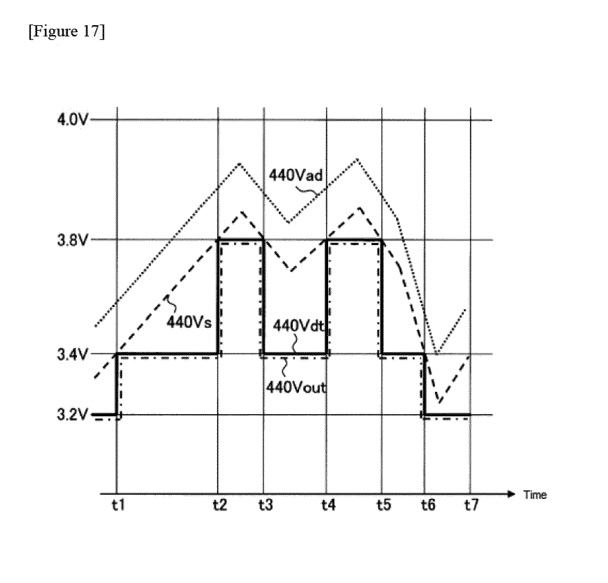

When the batteries are discharging, a case (called case D in the following) in which the A/D detection voltage value Vad in the change timing for the level determination signal is detected as higher than the determination voltage value Vdt because of an in-range failure will be considered. In Figure 17, the voltage waveforms for Vad, Vs, and Vdt in the case D are shown as dashed broken line 440Vad, dashed broken line 440Vs, and bold solid broken line 440Vdt, respectively. In Figure 16, furthermore, a voltage waveform example for Vout in case D is shown by the dashed broken line 440Vout. Moreover, the waveform 440Vout is shown somewhat offset from its true position for convenience of the display in the Figure.

In case D also, the digital circuit section 8 generates $Vdt_{DWN}(t)$ from Vdt(t) and outputs the smaller of $Vdt_{DWN}(t)$ and Vad(t) as Vout(t) (corresponding to step S58 in Figure 18, which will be described in the following). In the example in Figure 17, the use of Vdt itself for $Vdt_{DWN}$ is envisioned. In the example in Figure 17, $Vad(t) > Vdt_{DWN}(t) = Vdt(t)$ normally holds; therefore, $Vdt_{DWN}(t) = Vdt(t)$ is normally selected for Vout(t). As a result, the voltage waveform 440Vout, which matches the voltage waveform for $Vdt_{DWN}(t)$ (in other words, the voltage waveform 440Vdt) is obtained.

In the examples in Figure 16 and Figure 17, Vdt(t) itself is set as $Vdt_{DWN}(t)$, but $Vdt_{DWN}(t)$ may be generated by a correction that reduces Vdt(t) as described previously. In other words, for example, when Vdt(t) = Vref(i), $Vdt_{DWN}(t)$ may be set according to "$Vdt_{DWN}(t) = Vref(i + 1)$" or "$Vdt_{DWN}(t) = Vref(i + io)$" (io being an integer of 2 or more; see Figure 2). In addition, for example, $Vdt_{DWN}(t)$ may be set according to "$Vdt_{DWN}(t) = Vdt(t) - \Delta V$." Here, $\Delta V$ is a correction quantity having a prescribed value. A positive value can be set for $\Delta V$. The effect of restricting excessive discharging is increased by setting $\Delta V$ to a positive value, but $\Delta V$ may be made zero. When $\Delta V$ is zero, $Vdt_{DWN}(t)$ becomes Vdt(t) itself.

-- Flowchart of operation -- Next, the operating procedure for the battery system 1 will be described with reference to Figure 18 and with particular focus on the process for generating Vout. Figure 18 is a flowchart representing this operating procedure.

First of all, in step S50, the A/D detection voltage value Vad(t) at a time t is acquired from the A/D converter section 13. The acquisition process for Vad(t) in step S50 is executed periodically at a prescribed sampling period. In step S51, which follows step S50, the digital circuit section 8 confirms whether or not the level determination signal has changed. When a change to the level determination signal is confirmed, the processing in step S53 is executed after the processing in step S52 is executed, but when no change to the level determination signal is confirmed, the processing in step S53 is executed without executing the processing in step S52. In the example in Figure 13, changes to the level determination signal are confirmed at each of times t1, t2, t3, t4, t5, and t6.

In step S52, the digital circuit section 8 substitutes the determination voltage value Vdt (more accurately, the determination voltage value Vdt represented by the level determination signal after the change) in the timing in which the level determination signal is changed for the voltage value V1 and substitutes the A/D detection voltage value Vad at the timing of when the level determination signal is changed for the voltage value V2. Moreover, in the operations in Figure 18, V1 and V2 are handled as variables, and the initial values for V1 and V2 are the same.

In step S53, the digital circuit section 8 determines whether or not the voltage value V1 and the voltage value V2 match, and when the determination is that the voltage value V1 and the voltage value V2 match (Y in step S53), a determination is made that no in-range failure has occurred; in step S60, the most recent Vad(t) itself is output to the charging and discharging control section 9 (Figure 1) as Vout(t). Thereafter, the processing returns to step S50. On the other hand, when a determination was made that the voltage value V1 and the voltage value V2 do not match (N in step S53), a determination is made that an in-range failure has occurred, and the processing in step S54 is executed after step S53.

In step S54, whether the batteries are charging or discharging is confirmed by the digital circuit section 8, and when the batteries are charging, steps S55 and S57 are executed, and on the other hand, when the batteries are discharging, steps S56 and S58 are executed.

In step S55, the digital circuit section 8 sets Vdt(t) itself or Vdt(t) corrected by increasing as $Vdt_{UP}(t)$. The method for generating $Vdt_{UP}(t)$ from Vdt(t) is as described previously. In step S57, which follows step S55, the digital circuit section 8 selects the larger of $Vdt_{UP}(t)$ and Vad(t) acquired in step S50 as Vout(t). Vout(t) obtained by this selection is output to the charging and discharging control section 9 (see Figure 1) in step S59, and thereafter the processing returns to step S50. Moreover, the function MAX() shown in Figure 18 is a function that returns the largest value for the variable inside the parenthesis.

In step S56, the digital circuit section 8 sets Vdt(t) itself or Vdt(t) corrected by decreasing as $Vdt_{DWN}(t)$. The method for generating $Vdt_{DWN}(t)$ from Vdt(t) is as described previously. In step S58, which follows step S56, the digital circuit section 8 selects the smaller of $Vdt_{DWN}(t)$ and Vad(t) acquired in step S50 as Vout(t). Vout(t) obtained by this selection is output to the charging and discharging control section 9 (see Figure 1) in step S59, and thereafter the processing returns to step S50. Moreover, the function MIN() shown in Figure 18 is a function that returns the smallest value for the variable inside the parenthesis.

As described above, the determination voltage value Vdt and A/D detection voltage value Vad are set as V1 and V2 according to the timing at which the level determination signal changes, and the presence or absence of an occurrence of an in-range failure is detected by comparing V1 and V2 (steps S52 and S53). Furthermore, when an occurrence of an in-range failure is detected at the first time (for example time, t1 in Figure 13), Vout at the second time is determined (steps S55 - S58) based on the determination voltage value Vdt at the first time and the A/D detection voltage value Vad at the second time (for example, Vad at any time between the times t1 and t2 in Figure 13) while considering whether the batteries are being charged or being discharged. As above, the second time is the first time or any time after the first time.

In this instance, if the batteries are charging, $Vdt_{UP}(t)$ having a voltage value of Vdt(t) or greater is set, and the larger of $Vdt_{UP}(t)$ and Vad(t) is set as Vout(t) and output (steps S57 and S59). Thus, a voltage value on the safe side for overcharging is set for Vout; therefore, when an in-range failure occurs, the batteries can be charged safely.

In addition, if the batteries are discharging, $Vdt_{DWN}(t)$ having a voltage value of Vdt(t) or greater is set, and the smaller of $Vdt_{DWN}(t)$ and Vad(t) is set as Vout(t) and output (steps S58 and S59). Thus, a voltage value on the safe side for excessive discharging is set for Vout; therefore, when an in-range failure occurs, the batteries can be discharged safely.

«Fifth Embodiment»

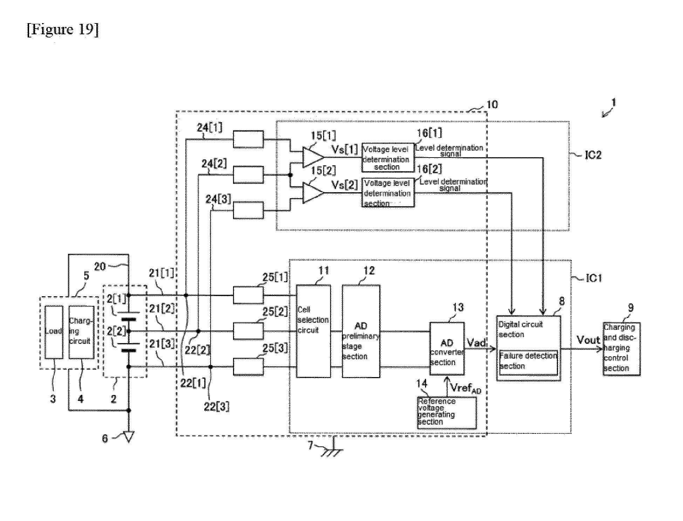

A fifth embodiment will be described. As is shown in Figure 19, the A/D converter section 13 and voltage level determination sections 16[i] can also be formed on separate integrated circuits. In Figure 19, integrated circuits IC1 and IC2, which are different from each other, are shown. In the example in Figure 19, the element numbers 11 - 14 and 8 are formed on the integrated circuit IC1, and the element numbers 15[1], 15 [2], 16[1] and 16[2] are formed on the integrated circuit IC2. Naturally, this is shown as an example, and the voltage detection section 10, digital circuit section 8 and charging and discharging control section 9 may be implemented by any number of integrated circuits; the components on integrated circuit IC 1 and the components on integrated circuit IC2 may be formed on a single integrated circuit.

«Sixth Embodiment»

A sixth embodiment will be described. The digital circuit section 8 shown in Figure 1 and the like can detect whether or not Vad is abnormal based on Vad. In other words, whether or not Vad is in a specific abnormal state can be detected based on Vad. The abnormality here is different from an abnormality in Vad because of an in-range failure. For example, when a comparatively severe failure arises in the A/D converter section 13 or the A/D preliminary stage section 12, the value for the digital voltage signal output by the A/D converter section 13 clings to the maximum value or minimum value for the digital value that the digital voltage signal can have. In other words, the value for the digital voltage signal is fixed at that maximum value or that minimum value for a set period or longer. When this fixing is detected, the digital circuit section 8 determines that Vad is in a specific abnormal state. Moreover, failures in which Vad is in a specific abnormal state are out-of-range failures. Out-of-range failures are comparatively severe failures that are not classified as in-range failures.

When Vad is detected as being in a specific abnormal state, the digital circuit section 8 sees the determination voltage value Vdt itself as the actual detection value Vout and outputs the same to the charging and discharging control section 9. Thus, even though the detection precision is degraded, detection of Vout can continue, and the carrying out of battery charging and discharging control can continue. Alternatively, when Vad is detected as being in a specific abnormal state and when the battery is charging, a voltage value $Vdt_{UP}$ that is larger than the determination voltage value Vdt is generated according to the method described in the fourth embodiment, and thereby the voltage value $Vdt_{UP}$ that is obtained is seen as the actual detection value Vout and output to the charging and discharging control section 9. Likewise, when Vad is detected as being in a specific abnormal state and when the battery is discharging, a voltage value $Vdt_{DWN}$ that is smaller than the determination voltage value Vdt is generated according to the method described in the fourth embodiment, and thereby the voltage value $Vdt_{DWN}$ that is obtained is seen as the actual detection value Vout and output to the charging and discharging control section 9. If $Vdt_{UP}$ or $Vdt_{DWN}$ is used, safe execution can continue by battery charging and discharging control. Moreover, when Vad is detected as being in a specific abnormal state, and an alarm notification may be sent to users using the display section (not shown in the drawings), a speaker (not shown in the drawings) or the like connected to the battery system 1.

«Seventh Embodiment»

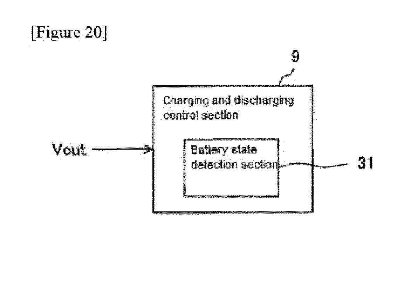

A seventh embodiment will be described. As is shown in Figure 20, a battery state detection section 31 may be present in the charging and discharging control section 9 shown in Figure 1. The battery state detection section 31 detects the state of the batteries based on the actual detection value Vout. Naturally, the state for the battery 2[1] is detected from the Vout for the battery 2[1], and the state for the battery 2[2] is detected from the Vout for the battery 2[2]. The state of the battery that is detected includes at least one of the internal resistance value and remaining capacity for the battery. The remaining capacity for the battery is a quantity proportional to the electric energy that can be output by the battery without charging the battery.

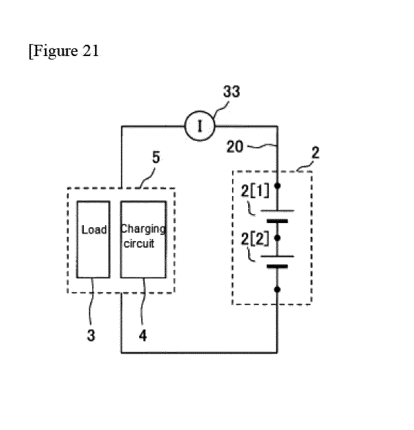

As is shown in Figure 21, a current sensor 33 that detects the current value passing through the main power line 20 is provided on the main power line 20. The current value detected by the current sensor 33 corresponds to the value of the output current for the batteries in the voltage source section 2; therefore, the current sensor 33 is a sensor that detects the output current value for the batteries. The output current value for the batteries detected by the current sensor 33 is called the detection current value.

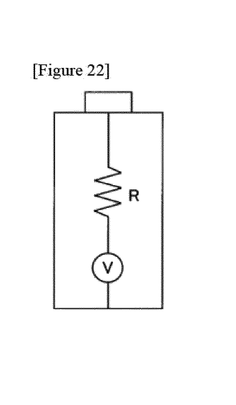

As was described in the first embodiment, the focus will be on one battery within the voltage source section 2, and a method for the detecting the internal resistance value and remaining capacity of the battery that is focused on will be described. As is shown in Figure 22, an equalization circuit in the battery can be seen as a series circuit with an ideal voltage source that does not have internal resistance and an internal resistance of resistance value R. The battery state detection section 31 can find the resistance value R according to Ohm's law based on the detection current value and Vout detected at a plurality of times. For example, during the charging of the battery, if the detection current value and the actual detection value Vout at the time t1 are 1 A (ampere) and 3.6 V, respectively, and the detection current value and the actual detection value Vout at the time t2 are 2 A (ampere) and 4.0 V, respectively, the resistance value R is detected as being 0.4 Ω by "R = (4.0 - 3.6)/(2-1) = 0.4." If the resistance value R is found, the detection current value and open circuit voltage value (output voltage for the battery when the output current value of the battery is zero) of the battery from Vout can also be detected, and the remaining capacity of the battery can also be detected.

Any method including publicly known methods may be used for the method for detecting the remaining capacity of the battery from the resistance value R. For example, when all or some of the resistance value R, detection current value and open circuit voltage value are input, a lookup table (not shown in the drawings) or calculation formula that outputs the value for the remaining capacity can be used. When an electric vehicle, which will be described in the following, that uses the battery system 1 is formed, the remaining capacity of the battery may be divided by the distance that can be driven by the electric vehicle, and that distance displayed to users using the display section (not shown in the drawings) or the like.

When an in-range failure occurs, Vout is different from Vad, but, by using Vout to detect the internal resistance value and the like rather than the Vad as described above, an internal resistance value or the like that compensates for or takes into consideration errors due to in-range failures can be obtained.

«Eighth Embodiment»

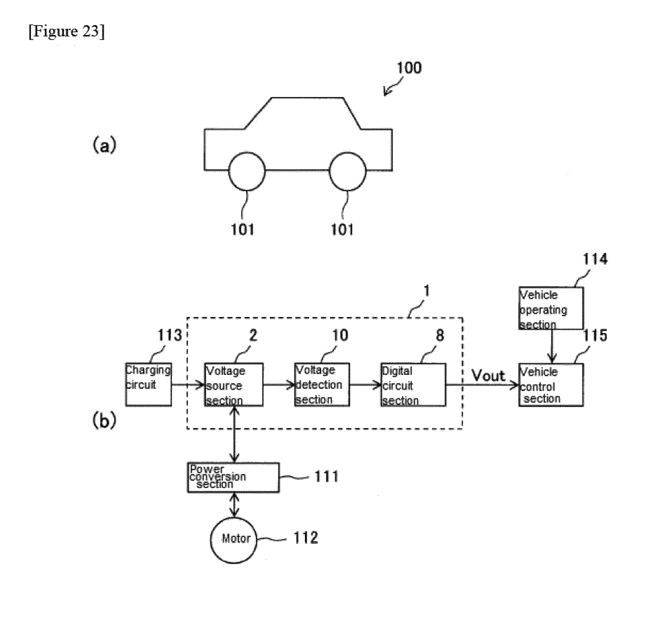

An eighth embodiment will be described. In the eighth embodiment, an electric vehicle that uses the battery system 1 will be described. Figure 23 (a) is an external appearance surface drawing of an electric vehicle 100 according to the eighth embodiment, and Figure 23 (b) is a schematic block diagram of the electric vehicle 100 focusing on a drive system for the electric vehicle 100. A plurality of drive wheels 101 are provided on the electric vehicle 100.

As is shown in Figure 23 (b), the electric vehicle 100 comprises a battery system 1 that includes a voltage source section 2, voltage detection section 10 and digital circuit section 8, a power conversion section 111, a motor 112, a charging circuit 113, a vehicle operating section 114 and a vehicle control section 115.

The power conversion section 111 is formed from a PWM (pulse width modulation) inverter or the like, and when there is a need to supply power to the motor 112, the output direct current voltage of the voltage source section 2 is converted to alternating current voltage power and supplied to the motor 112 under the control of the vehicle control section 115. When regenerative electric power is generated by the motor 112, the regenerative electric power from the motor 112 is converted to direct current power and supplied to the voltage source section 2 under the control of the vehicle control section 115. The batteries in the voltage source section 2 can be charged by the regenerative electric power from the motor 112. When, as is shown in Figure 1, the voltage source section 2 is formed from a series circuit of the battery 2[1] and the battery 2[2], the output direct current voltage of the voltage source section 2 is the output voltage of that series circuit.

The motor 112 rotates with the output direct current voltage of the voltage source section 2 as a drive source. However, at times such as those when regenerative electric power is being generated, the motor 112 may rotate regardless of the output direct current bolted of the voltage source section 2. The drive wheels 101 are rotationally driven using the torque generated by the motor 112, and electric vehicle 100 is driven on a road surface by the rotational drive of the drive wheels 101.

The charging circuit 113 is a charging circuit for charging the batteries in the voltage source section 2 using an electric power source different from the regenerative electric power of the motor 112. In the electric vehicle 100, the motor 112 and the charging circuit 113 function as the load 3 and charging circuit 4 (see Figure 1), respectively, and when regenerative electric power is being generated, the power conversion section 111 and motor 112 also function as the charging circuit 4.

The vehicle operating section 114 is a part that gives instructions regarding the driving of the electric vehicle 100, and for example, includes an accelerator pedal that gives instructions for acceleration of the electric vehicle 100 and a brake pedal that gives instructions for the deceleration of the electric vehicle 100.

The vehicle control section 115 has the functions for the charging and discharging control section 9 shown in Figure 1 and the like. Vout from the digital circuit section 8 is transmitted to the vehicle control section 115. The vehicle control section 115 controls the rotational state of the motor 112 by controlling the power conversion section 111 using Vout, thereby controlling the running state of the electric vehicle 100 while following the content of instructions from a driver to the vehicle operating section 114. In addition, the vehicle control section 115 checks whether the batteries in the voltage source section 2 are in an overcharging state or excessive discharging state using Vout and controls the power conversion section 111 and charging circuit 113 such that charging of the batteries is stopped when the batteries are in an overcharging the state, and discharging of the batteries is stopped when the batteries are in an excessive discharging state. When the vehicle control section 115 determines that the state of the batteries is an overcharging state or an excessive discharging state, the driver is notified to that effect using the display section or speaker mounted in the electric vehicle 100. For the display section and speaker mounted in the electric vehicle 100, those for a car navigation system mounted in the electric vehicle 100 can be used.

When occurrences of in-range failures are detected, the operation of the electric vehicle 100 can be stopped immediately. However, in-range failures are comparatively mild failures; therefore, it cannot always be said that immediately stopping the operation of the electric vehicle 100 when an in-range failure is detected is always the best measure. When an in-range failure occurs in the electric vehicle 100, running control of the electric vehicle 100 is carried out through the charging and discharging control of the batteries using Vout set to a voltage value on the safe side; therefore, even when an in-range failure occurs, the electric vehicle 100 can be run safely.

Moreover, the electric vehicle 100 may be an electric vehicle that runs using only the batteries in the voltage source section 2 as the drive source, and may also be a hybrid electric vehicle that runs using the batteries in the voltage source section 2 and an energy source other than the batteries (for example fossil fuels) jointly as the drive source. In addition, in Figure 23 (a), an automobile is shown for the electric vehicle 100, but the electric vehicle 100 may be a motorcycle or the like.

In addition, an example of using the battery system 1 in the electric vehicle 100 was described above, but the battery system 1 can be used in any equipment other than the electric vehicle 100. This equipment includes electric power tools, personal computers, mobile telephones, information terminals and the like that are driven using the output power of the batteries in the voltage source section 2.

«Ninth Embodiment»

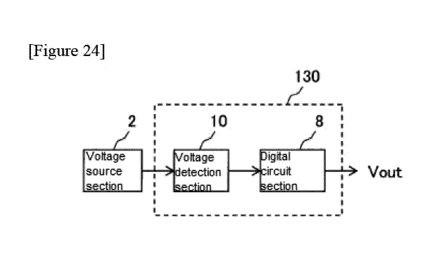

A ninth embodiment will be described. As is shown in Figure 24, a device formed from the voltage detection section 10 and the digital circuit section 8 can be thought of as a battery voltage detection device (or battery control device) 130. As was described in the fifth embodiment (see Figure 19), the battery voltage detection device 130 may also be formed from a single chip integrated circuit or may be formed from integrated circuits on a plurality of integrated circuits.

«Tenth Embodiment»

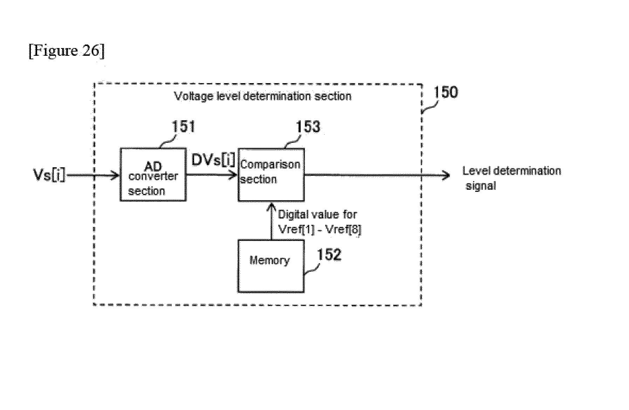

A tenth embodiment will be described. In the specific example of the voltage level determination sections 16[i] described above (see Figure 2), the determination for the voltages Vs[i] (determination of the values for the voltages Vs[i]) was carried out by comparing the voltages Vs[i], which are the object of measurements, to reference voltages Vref[1] - [8] at the analog signal stage, but that comparison and determination may be carried out at the digital signal stage. In other words, for example, a voltage level determination section 150 shown in Figure 26 may be used for the voltage level determination sections 16[i].

The voltage level determination section 150 comprises an A/D converter section 151 that converts the analog signals for the analog voltages Vs[i] into digital signals DVs[i], a memory 152 that stores a plurality of digital values that represent the plurality of voltage values, and a comparison section 153 that generates and outputs the level determination signal by comparing the plurality of digital values stored in the memory 152 and the values for the digital signals DVs[i]. The level determination signal from the comparison section 153 is sent to the digital circuit section 8 (see Figure 1). Specifically, for example the memory 152 can store digital values that represent the reference voltages Vref[1] - Vref[8] as a plurality of digital values, and in this case, the level determination signal generated by the comparison section 153 is equivalent to the level determination signal generated by the voltage level determination sections 16[i] in Figure 2. In both the voltage level determination sections 16[i] Figure 2 and the voltage level determination section 150 in Figure 26, there is no difference in the analog voltages Vs[i] that are the object of measurements being determined and the level determination signal being generated and output according to the those determination results.

«Eleventh Embodiment»

A Eleventh embodiment will be described. The following can be said about the electric vehicle 100 described in the eighth embodiment (see Figure 23 (a) and (b)). The electric vehicle 100 comprises a vehicle body and drive wheels 101, and the various parts shown in Figure 23 (b) are provided inside the vehicle body. The vehicle operating section 114 comprises an accelerator section, which includes an accelerator pedal, for giving instructions for acceleration of the vehicle body and a brake section, which includes a brake pedal, for giving instructions for decelerating the vehicle body. In the electric vehicle 100, the motor 112 receives electric power from the batteries in the battery system 1, converts that electric power into mechanical power and moves the vehicle by rotating the drive wheels 101 by that mechanical power. In the electric vehicle 100, the vehicle body can be thought of as corresponding to the moving body main part, the motor 112 as corresponding to the mechanical power source and the drive wheels 101 as corresponding to the drive section.

The electric vehicle 100 is an example of a moving body in which the battery system 1 is mounted and the battery system 1 may be mounted in other moving bodies such as boats, aircraft, elevators or walking robots.

A boat in which the battery system 1 is mounted comprises, for example, along with comprising the power conversion section 111 and motor 112, a boat body, screw, acceleration input section and deceleration input section in place of the vehicle body, drive wheels 101, acceleration section and brake section, respectively, for the electric vehicle 100. The driver operates the acceleration input section instead of the acceleration section when accelerating the boat body and operates the deceleration input section instead of the brake section when decelerating the boat body (same for the aircraft and the like that will be described in the following). However, a boat may be constituted such that a deceleration input section cannot be provided. In this boat, the motor 112 receives electric power from the batteries in the battery system 1, converts that electric power into mechanical power and moves the boat body by rotating the screw by that mechanical power. In the boat described above, the boat body can be thought of as corresponding to the moving body main part, the motor 112 as corresponding to the mechanical power source and the screw as corresponding to the drive section.

An aircraft in which the battery system 1 is mounted comprises, for example, along with comprising the power conversion section 111 and motor 112, an aircraft body, a propeller, acceleration input section and deceleration input section in place of the vehicle body, drive wheels 101, acceleration section and brake section, respectively, for the electric vehicle 100. However, and aircraft may be constituted such that a deceleration input section cannot be provided. In this aircraft, the motor 112 receives electric power from the batteries in the battery system 1, converts that electric power into mechanical power and moves the aircraft body by rotating the propeller by that mechanical power. In the aircraft described above, the aircraft body can be thought of as corresponding to the moving body main part, the motor 112 as corresponding to the mechanical power source and the propeller as corresponding to the drive section.

An elevator in which the battery system 1 is mounted comprises, for example, along with comprising the power conversion section 111 and motor 112, a cage, a raising and lowering rope attached to the cage, acceleration input section and deceleration input section in place of the vehicle body, drive wheels 101, acceleration section and brake section, respectively, for the electric vehicle 100. In this elevator, the motor 112 receives electric power from the batteries in the battery system 1, converts that electric power into mechanical power and raises and lowers the cage by rolling up the raising and lowering rope by that mechanical power. In the elevator described above, the cage can be thought of as corresponding to the moving body main part, the motor 112 as corresponding to the mechanical power source and the raising and lowering rope as corresponding to the drive section.

A walking robot in which the battery system 1 is mounted comprises, for example, along with comprising the power conversion section 111 and motor 112, a body trunk, legs, acceleration input section and deceleration input section in place of the vehicle body, drive wheels 101, acceleration section and brake section, respectively, for the electric vehicle 100. In this walking robot, the motor 112 receives electric power from the batteries in the battery system 1, converts that electric power into mechanical power and moves the body trunk by driving the legs by that mechanical power. In the walking robot described above, the body trunk can be thought of as corresponding to the moving body main part, the motor 112 as corresponding to the mechanical power source and the legs as corresponding to the drive section.

As described above, in the moving body in which the battery system 1 is mounted, the mechanical power source receives electric power from the batteries in the battery system 1 (for example, receives the electric power through the power conversion section 111) and converts that electric power into mechanical power, and the drive section drives the moving body main part using the mechanical power obtained by the mechanical power source.

«Twelfth Embodiment»

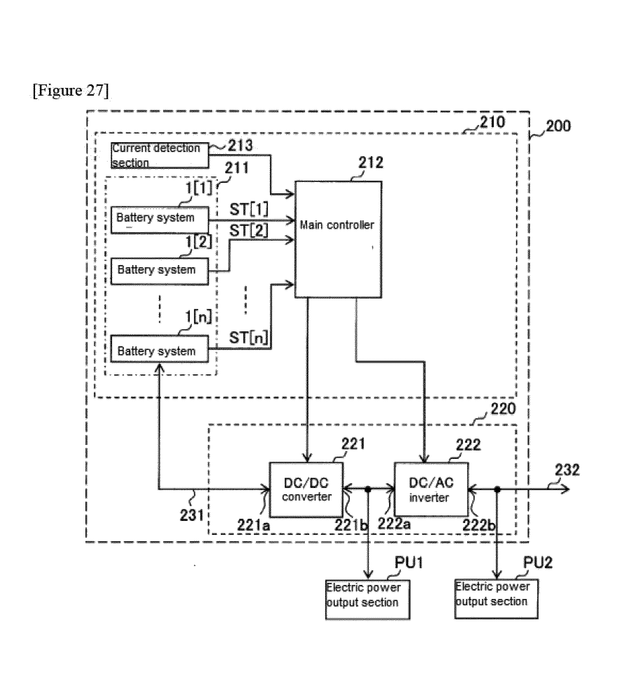

A twelfth embodiment will be described. Figure 27 is a block diagram showing the constitution of a power supply device 200 according to a twelfth embodiment of the present invention. The power supply device 200 comprises an electric power storage device 210 and a power conversion device (power conversion section) 220. The electric power storage device 210 comprises a battery system unit (battery system group) 211 formed from n battery systems 1 [1] - 1 [n], a main controller 212 and a current detection section 213. In the present embodiment, n is an integer of 2 or more. However, n may also be 1.

The battery systems 1[1] - 1[n] are each the same as the battery system 1 described above and comprise the voltage source section 2, voltage detection section 10, digital circuit section 8, and charging and discharging control section 9 in Figure 1. The battery systems 1[1] - 1[n] are connected in series or in parallel to each other. In the present example, the battery systems 1 [1] - 1 [n] are connected to each other in series, and as a result, all of the batteries in the battery systems 1 [1] - 1 [n] are made to be connected to each other in series. The negative electrode (negative output terminal) for the battery having the lowest potential and the positive electrode (positive output terminal) for the battery having the highest potential among all of the batteries in the battery systems 1 [1] - 1 [n] are connected to the power conversion device 220 through the power line 231.
The current detection section 213 detects the current flowing in a power line 231, in other words, detects the value of the current across the battery system unit 211 and the power conversion device 220 and outputs the detection current value to the main controller 212.

In the battery systems 1 [i], the charging and discharging control section 9 outputs state signals ST[i] based on the actual detection value Vout from the digital circuit section 8. The state signals ST[i], for example, include a charge enabling signal that indicates charge enabling for the batteries in the battery systems 1 [i], a charge disabling signal that indicates charge disabling for the batteries in the battery systems 1 [i], a discharge enabling signal that indicates this charge enabling for the batteries in the battery systems 1 [i] and a discharge disabling signal that indicates this charge disabling for the batteries in the battery systems 1[i]. Furthermore, according to necessity, a charging required signal for requiring charging of the batteries in the battery systems 1[i] and a discharging required signal for requiring discharging of the batteries in the battery systems 1 [i] are included, and an in-range failure the current signal that represents the occurrence of an in-range failure when an in-range failure occurs in the battery systems 1[i] is included. The outputting of the state signals ST[i] to the main controller 212 is brought about for each of the battery systems 1[1] - 1[n].

The power conversion device 220 comprises a DC/DC converter 221 and a DC/AC converter 222. The DC/DC converter 221 is provided with input and output terminals 221a and 221b, and the DC/AC converter 222 is provided with input and output terminals 222a and 222b. The input and output terminal 221a for the DC/DC converter 221 is connected to the battery system unit 211 via the power line 231. The input and output terminals 221b and 222a are connected to each other and are connected to an electric power output section PU1. The input and output terminal 222b is connected to an electric power output section PU2 and power supply system 232, which is a separate power system from the power supply device 200. Moreover, the connections of the power conversion device 200 and the electric power output sections PU1 and PU2 are not required.

As an example of external equipment, the electric power output sections PU1 and PU2 include electric sockets. For example, a variety of loads may be connected to electric power output sections PU1 and PU2. The electric power output sections PU1 and PU2 may each be thought of as a load. The power system 232 includes commercial power sources and solar cells. Solar cells may also be connected to the input and output terminals 221b, and in this case, direct current voltage can be supplied to the input and output terminals 221b based on the power generation of the solar cells. When a solar cell system comprising solar cells and a power conditioner is used as a power system 232, the AC output section (AC output section) of the power conditioner can be connected to the input and output terminal 222b. The power conversion device 220 carries out power conversion between the batteries in the battery systems 1 [1] - 1 [n] and the electric power output sections PU1 and PU2 or the power system 232 using the DC/DC converter 221 and DC/AC converter 222 under the control of the main controller 212.

The main controller 212 controls the charging and discharging of the batteries in the battery systems 1[1] - 1 [n] by controlling the DC/DC converter 221 and DC/AC converter 222 based on the detection current values according to the current detection section 213 and the state signals ST[1] - ST[n]. However, the main controller 212 may be made to control only the charging or only the discharging of the batteries in the battery systems 1 [1] - 1 [n].

For example, when the state signals ST[1] - ST[n] each contain a discharge enabling signal or a discharging required signal, the DC/DC converter 221 converts the output direct current power of the battery system unit 211 to other direct current power based on the output power of the batteries in the battery systems 1[1] - 1[n] under the control of the main controller 212 and outputs the other direct current power from the input and output terminal 221b. The DC/AC converter 222 converts the direct current power from the input and output terminal 221b into alternating current power and outputs that alternating current power from the input and output terminal 222b.

Alternatively, when the state signals ST[1] - ST[n] each contain a charge enabling signal and charging required signal, for example, the DC/AC converter 222 converts the alternating current power from the power system 232 to direct current power and outputs the direct current power from the input and output terminal 222a under the control of the main controller 212, and the DC/DC converter 221 converts the direct current power from the input and output terminal 222a to other direct current power and outputs that other direct current power from the input and output terminal 221a. Thus, the batteries in the battery systems 1 [1] - 1 [n] are charged by the direct current power from the input and output terminal 221a.

In the constitution described above, the main controller 212 is an example of the charging and discharging control unit that carries out control for charging and discharging of the batteries in the battery systems 1[1] - 1[n]. The main controller 212 can be thought of as forming a charging and discharging control unit along with the charging and discharging control section 9 (see Figure 1) in the battery systems 1[1] - 1[n].

In the example of a constitution described above the providing of the charging and discharging control section 9 in the battery systems 1 [i] was envisioned, but the charging and discharging control section 9 may be eliminated from each of the battery systems 1[1] - 1 [n], and the actual detection value Vout from the digital circuit sections 8 in the battery systems 1 [1] - 1 [n] may be given to the main controller 212. In this case, the main controller 212 has functions combining the plurality of charging and discharging control sections 9 that were eliminated, and may determine whether or not charging of the batteries in the battery systems 1 [1] - 1 [n] should be carried out and control the power conversion device 220 according to those determination results based on the actual detection value Vout from the digital circuit sections 8.

In addition, the electric power storage device 210 and power supply device 200 may be formed such that only one battery system 1 (for example battery system 1[1]) is included in the battery system unit 211, though this differs from the example of the constitution in Figure 27.

Suitable and various changes to the embodiments of the present invention are possible within the scope of the technical concepts given in the claims. The embodiments above, are nothing more than single embodiments of the present invention, and the meaning of the terms used for the present invention or the constituent elements are not restricted by the descriptions in the embodiments above. The specific numerical values shown in the descriptive text above are simply showing examples, and as is natural, they may be changed to various numerical values.

**EXPLANATION OF THE ELEMENTS**

1 battery system
2 voltage source section
2[i] battery
3 load
4 charging circuit
5 charging and discharging section

8 digital circuit section
9 charging and discharging control section
10 voltage detection unit
13 A/D converter section
16, 16[i] voltage level determination section
31 battery state detection section
100 electric vehicle
101 drive wheel
112 motor
115 vehicle control section
130 battery voltage detection device
150 voltage level determination section
200 power supply device
210 electric power storage device
220 power conversion device

Now that the invention has been described, what is claimed is:

**Claims**

1. A battery system comprising:

   a battery for a voltage source of an analog voltage that is the object of measurements and which can be charged and discharged and
   a voltage detection section that has an A/D converter section that converts an analog voltage signal for the analog voltage that is the object of measurements to a digital voltage signal and outputs an A/D detection voltage value according to that digital voltage signal and a voltage level determination section that outputs a level determination signal that expresses size relationships between the analog voltage that is the object of measurements and various reference voltages by comparing the analog voltage that is the object of measurements with a plurality of reference voltages and detects the output voltage value for the battery from the A/D detection voltage value, wherein
   the battery system further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value and when the battery is charging and when the occurrence of a failure at the first time is detected, the output voltage value is detected at a second time based on the determination voltage value at the first time and the A/D detection voltage value at the second time which is a time matching the first time or subsequent to the first time.

2. A battery system comprising:

   a battery for a voltage source of an analog voltage that is the object of measurements and which can be charged and discharged and a voltage detection section that has an A/D converter section that converts an analog voltage signal for the analog voltage that is the object of measurements to a digital voltage signal and outputs an A/D detection voltage value according to that digital voltage signal and a voltage level determination section that outputs a level determination signal according to the determination results for the analog voltage that is the object of measurements and detects the output voltage value for the battery from the A/D detection voltage value, wherein
   the battery system further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value and when the battery is charging and when the occurrence of a failure at the first time is detected, the output voltage value is detected at a second time based on the determination voltage value at the first time and the A/D detection voltage value at the second time which is a time matching the first time or subsequent to the first time.

3. The battery system according to claim 1 or claim 2 wherein,

when the battery is discharging and when the occurrence of the failure is detected at the first time, the output voltage value at the second time is detected based on the determination voltage value at the first time and the A/D detection voltage value at the second time.

4. The battery system according to claim 1 or claim 2 wherein, when the battery is being charged and when the occurrence of a failure is detected at the first time, and the determination voltage value detected at the first time is larger than the A/D detection voltage value at the first time, the output voltage value at the second time is detected by a correction that increases the A/D detection voltage at the second time using either or both of the ratio of the determination voltage value at the first time and the A/D detection voltage value and difference between the determination voltage value at the first time and the A/D detection voltage value.

5. The battery system according to claim 3 wherein, when the battery is being discharged and when the occurrence of a failure is detected at the first time and the determination voltage value detected at the first time is smaller than the A/D detection voltage value at the first time, the output voltage value at the second time is detected by a correction that decreases the A/D detection voltage at the second time using either or both of the ratio of the determination voltage value at the first time and the A/D detection voltage value and difference between the determination voltage value at the first time and the A/D detection voltage value.

6. The battery system according to claim 1 or claim 2 wherein, when the battery is being charged and when the occurrence of a failure is detected at the first time, a voltage value for comparison equal to or greater than the determination voltage value at the first time is set and the larger of the voltage value for comparison and the A/D detection voltage value at the second time is detected as the output voltage value at the second time.

7. The battery system according to claim 3 wherein, when the battery is being discharged and when the occurrence of a failure is detected at the first time, a voltage value for comparison that less than or equal to the determination voltage value at the first time is set and the smaller of the voltage value for comparison and the A/D detection voltage value at the second time is detected as the output voltage value at the second time.

8. The battery system according to claim 1 or claim 2 wherein the failure detection section can detect whether or not the A/D detection voltage value is in an abnormal state based on the A/D detection voltage value and when the A/D detection voltage value is detected as being in a specific abnormal state, the battery system detects a voltage value according to the determination voltage value as the output voltage value.

9. The battery system according to claim 1 or claim 2 wherein the battery system further comprises a battery state detection section that detects either or both of an internal resistance value for the battery and a remaining capacity for the battery based on the output voltage value that has been detected.

10. An electric vehicle comprising: the battery system according to claim 1 or claim 2, a rotating motor that uses the output of the battery in the battery system, drive wheels that drive by the rotation of the motor, and a vehicle control section that controls the rotational state of the motor based on the output voltage value detected in the battery system.

11. A moving body comprising: the battery system according to claim 1 or claim 2, a moving body main part, a mechanical power source that converts the electric power from the battery in the battery system to mechanical power and a drive section that moves the moving body main part by the mechanical power from the mechanical power source.

12. An electric power storage device comprising: the battery system according to claim 1 or claim 2, and a charging an discharging control unit that carries out control for charging or discharging of the battery in the battery system.

13. A power supply device that can be connected to external equipment or a power system, comprising:

the electric power storage device according to claim 12 and
an electric power conversion device that carries out electric power conversion between the battery in the electric power storage device and the external equipment or power system under the control of the charging and discharging control unit in the electric power storage device.

14. A battery voltage detection device comprises: a voltage detection section that has an A/D converter section that converts an analog voltage signal for an analog voltage that is output by a battery that can be charged and discharged and that is the object of measurements to a digital voltage signal and outputs an A/D detection voltage value according to that digital voltage signal and a voltage level determination section that outputs a level determination signal that expresses size relationships between the analog voltage that is the object of measurements and various reference voltages by comparing the analog voltage that is the object of measurements with a plurality of reference voltages and detects the output voltage value for the battery from the A/D detection voltage value, wherein this voltage detection device further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes with the A/D detection voltage value and when the battery is charging and when the occurrence of a failure at the first time is detected, the output voltage value is detected at a second time based on the determination voltage value at the first time and the A/D detection voltage value at the second time which is a time matching the first time or subsequent to the first time.

15. A battery voltage detection device comprises a voltage detection section that has an A/D converter section that converts an analog voltage signal for the analog voltage that is output by a battery that can be charged and discharged and that is the object of measurements to a digital voltage signal and outputs an A/D detection voltage value according to that digital voltage signal and a voltage level determination section that outputs a level determination signal according to the determination results for the analog voltage that is the object of measurements and detects the output voltage value for the battery from the A/D detection voltage value, wherein this voltage detection device further comprises a failure detection section that detects the presence or absence of occurrences of failures in the battery voltage detection section by comparing the determination voltage value for the analog voltage that is the object of measurements shown by the level determination signal at a first time corresponding to the timing at which the level determination signal changes and when the battery is charging with the A/D detection voltage value and when the occurrence of a failure at the first time is detected, the output voltage value is detected at a second time based on the determination voltage value at the first time and the A/D detection voltage value at the second time, which is a time matching the first time or subsequent to the first time.

[Figure 1]

[Figure 2]

Level determination signal

[Figure 3]

[Figure 4]

[Figure 5]

[Figure 6]

16

Vs → | Voltage level determination section | → Level determination signal (determination voltage value Vdt)

[Figure 7]

| Cause of failure | Example of failure location |
|---|---|
| 1. Reference folders abnormality on A/D converter section side | Reference voltage generating section |
| 2. Leak current abnormality on A/D converter section side | A/D preliminary stage section cell selection circuit |
| 3. Offset abnormality on A/D converter section side | A/D preliminary stage section A/D converter section |
| 4. Reference value abnormality on voltage level determination section side | VrefA and VrefV generating circuit |
| 5. Leak current abnormality on voltage level determination section side | Buffer amplifier comparator |
| 6. Offset abnormality on voltage level determination section side | Buffer amplifier comparator |

[Figure 8]

[Figure 9]

[Figure 10]

```
                        ┌─────────────┐
                        │    START    │
                        └──────┬──────┘
                               │
              ┌────────────────▼────────────────┐
      S10     │ Acquire A/D detection           │
              │ voltage value Vad               │
              └────────────────┬────────────────┘
                               │
      S11          ┌───────────▼──────────┐    N
                   │ Level determination  ├─────────
                   │ signal changed?      │        │
                   └───────────┬──────────┘        │
                               │ Y                 │
      S12  ┌────────────────────▼──────────────────┐
           │Substitute determination voltage value │
           │Vdt and A/D detection voltage value Vad│
           │at change timing for level determination│
           │signal into V1 and V2                  │
           └────────────────────┬──────────────────┘         S22
                                │                       ┌──────────────┐
      S13          ┌────────────▼──────┐   Y            │ Output Vad   │
                   │   V1 = V2 ?       ├───────────────>│ as Vout      │
                   └────────────┬──────┘  No in-range   └──────────────┘
      In-range failure present  │ N        failure
                                │
      S14          ┌────────────▼──────┐   N
                   │   V1 > V2 ?       ├────────────────────────────
                   └────────────┬──────┘                           │
                                │ Y                            S16 │
      S15      ┌────────────────▼───┐  N                  ┌────────▼─────────┐ Y
               │  Charging?         ├──────┐    S19        │  Charging?       ├────
               └────────────────┬───┘      │              └────────┬─────────┘   │
                                │ Y   S18  ▼                       │ N           │
                                │   ┌──────────┐  ┌──────────┐     ▼             │
                                │   │ Vout=Vad │  │ Vout=Vad │                   │
                                │   └──────────┘  └──────────┘                   │
      S17                       │                        S20                     │
```

**S17**
Determine Vout by first or second correction method
— first correction method:
Set larger of Va and Vb as Vout.
$Va = Vad \cdot V1/V2$
$Vb = Vad + (V1 - V2)$
— Second correction method:
$Vout = Vad \cdot V1/V2 + (V1 - V2)$

**S20**
Determine Vout by third or fourth correction method
— third correction method:
Set smaller of Va and Vb as Vout.
$Va = Vad \cdot V1/V2$
$Vb = Vad + (V1 - V2)$
— Fourth correction method:
$Vout = Vad \cdot V1/V2 + (V1 - V2)$

**S21** Output Vout

S10

[Figure 11]

```
                    ┌──────────────┐
                    │    START     │
                    └──────┬───────┘
                           │ ←──────────────────────────────┐
              ┌────────────▼────────────┐                   │
        S10   │ Acquire A/D detection   │                   │
              │ voltage value Vad       │                   │
              └────────────┬────────────┘                   │
                           │                                │
        S11        ╱───────▼────────╲        N              │
              ╱ Level determination signal ╲──────────┐     │
               ╲      changed?     ╱               │     │
                ╲─────────┬───────╱                │     │
        S12           Y   │                        │     │
        ┌──────────────────▼──────────────────────┐│     │
        │ Substitute determination voltage value  ││     │
        │ Vdt and A/D detection voltage value Vad ││     │
        │ at change timing for level determination││     │
        │ signal into V1 and V2                   ││     │
        └──────────────────┬──────────────────────┘│     │
                           │ ←─────────────────────┘      │
        S13        ╱───────▼────────╲   Y     ┌───────────┴──┐
                  ╱    V1=V2 ?       ╲────────▶│ S22          │
                   ╲────────┬───────╱  No in-  │ Output Vad   │
                            │      range       │ as Vout      │
         In-range failure   │ N    failure     └──────────────┘
         present            │
        S14        ╱────────▼───────╲   N
                  ╱    V1 > V2 ?     ╲───────────────────┐
                   ╲───────┬────────╱                    │
                        Y  │                             │
        S15    ╱──────────▼─────╲  N              S16   ╱─▼──────────╲
              ╱   Charging?      ╲─────┐   S19  Y╱   Charging?       ╲
               ╲────────┬───────╱      │ S18  ┌─╱─╲──────────┬───────╱
                     Y  │        ┌─────▼──┐ ┌─▼────────┐   N │
                        │        │Vout=Vad│ │Vout=Vad  │     │
                        │        └────┬───┘ └────┬─────┘     │
        S17a            │             │          │           │
        ┌───────────────▼──────┐      │  S20a    │  ┌────────▼──────────┐
        │                      │      │          │  │                   │
        │  Vout=Vad·V1/V2      │      │          │  │  Vout=Vad·V1/V2   │
        │                      │      │          │  │                   │
        └──────────┬───────────┘      │          │  └─────────┬─────────┘
                   │                  │          │            │
                   └──────────────────┼──────────┴────────────┘
                                      │
                              ┌───────▼──────┐
                        S21   │ Output Vout  │
                              └───────┬──────┘
                                      │
                                   S10 ∧
```

[Figure 12]

```
                    ┌──────────────┐
                    │    START     │
                    └──────┬───────┘
                           │
                           ▼
        ┌──────────────────────────────┐
   S10  │ Acquire A/D detection         │
        │ voltage value Vad             │
        └──────────────┬────────────────┘
                       │
                       ▼
   S11    ╱─────────────────────╲      N
        ╱  Level determination    ╲──────────┐
        ╲   signal changed?       ╱           │
          ╲─────────────────────╱             │
                   │ Y                         │
   S12             ▼                           │
        ┌──────────────────────────────────┐  │
        │ Substitute determination voltage  │  │
        │ value Vdt and A/D detection       │  │
        │ voltage value Vad at change       │  │
        │ timing for level determination    │  │
        │ signal into V1 and V2             │  │
        └──────────────┬────────────────────┘  │
                       │            S22         │
   S13                 ▼     ┌──────────────┐   │
        ╱───────────╲   Y    │ Output Vad as│   │
        ╲   V1=V2 ?  ╲──────▶│ Vout         │───┘
          ╲─────────╱  No in-range└────────┘
In-range failure │ N  failure
 present         ▼
   S14    ╱───────────╲      N
        ╱   V1＞V2 ?   ╲───────────────────────┐
        ╲─────────────╱                        │
              │ Y                    S16        ▼
   S15        ▼        S18   S19    ╱───────────╲
        ╱──────────╲ N  ┌────────┐ ┌────────┐ Y ╱  Charging? ╲
        ╲ Charging? ╱──▶│Vout=Vad│ │Vout=Vad│◀──╲           ╱
          ╲────────╱    └───┬────┘ └───┬────┘    ╲─────────╱
              │ Y           │          │              │ N
   S17b       ▼             │          │    S20b      ▼
   ┌────────────────────┐   │          │   ┌────────────────────┐
   │                    │   │          │   │                    │
   │  Vout=Vad+(V1−V2)  │   │          │   │  Vout=Vad+(V1−V2)  │
   │                    │   │          │   │                    │
   └──────────┬─────────┘   │          │   └─────────┬──────────┘
              │             │          │             │
              └──────────┐  │          │  ┌──────────┘
                         │  │          │  │
                         ▼  ▼          ▼  ▼
                      S21  ┌──────────────┐
                           │ Output Vout  │
                           └──────┬───────┘
                                  ▼
                              S10 へ
```

[Figure 13]

[Figure 14]

[Figure 15]

[Figure 16]

[Figure 17]

[Figure 18]

```
                    ┌──────────────┐
                    │    START     │
                    └──────┬───────┘
                           │ ◄──────────────────────────┐
            ┌──────────────▼──────────┐                 │
      S50   │ Acquire A/D detection   │                 │
            │ voltage value Vad(t)    │                 │
            └──────────────┬──────────┘                 │
                           │                            │
      S51        ╱─────────▼─────────╲     N            │
              ╱  Level determination  ╲──────────┐      │
              ╲  changed?             ╱          │      │
                ╲─────────┬─────────╱            │      │
      S52              Y  │                      │      │
       ┌─────────────────▼────────────────┐     │      │
       │ Substitute determination voltage │     │      │
       │ value Vdt and A/D detection       │     │      │
       │ voltage value Vad at change       │     │      │
       │ timing for level determination    │     │      │
       │ signal into V1 and V2             │     │      │
       └─────────────────┬────────────────┘     │      │
                         │◄─────────────────────┘      │
      S53          ╱─────▼─────╲    Y       S60         │
                 ╱   V1=V2 ?    ╲──────► ┌────────────┐ │
                 ╲             ╱  No in- │Output Vad(t)│─┘
                   ╲────┬────╱   range   │as Vout(t)   │
   In-range failure     │ N   failure   └────────────┘
   present              │
      S54          ╱────▼────╲    N
                 ╱ Charging?   ╲──────────────────┐
                 ╲            ╱                    │
                   ╲───┬────╱                      │
      S55           Y  │                 S56       │
       ┌───────────────▼──────────┐    ┌───────────▼──────────┐
       │ Set Vdt(t) itself or     │    │ Set Vdt(t) itself or │
       │ Vdt(t) corrected by      │    │ Vdt(t) corrected by  │
       │ increasing in VdtUP(t)   │    │ increasing in        │
       │                          │    │ VdtDWN(t)            │
       └───────────────┬──────────┘    └───────────┬──────────┘
      S57              │                 S58        │
       ┌───────────────▼──────────┐    ┌───────────▼──────────┐
       │ Vout(t) = MAX(Vdt_UP(t), │    │ Vout(t) = MIN(       │
       │          Vad(t))         │    │ Vdt_DWN(t),Vad(t))   │
       └───────────────┬──────────┘    └───────────┬──────────┘
                       │                           │
                       └─────────────┬─────────────┘
                              ┌───────▼───────┐
                        S59   │ Output Vout(t)│
                              └───────┬───────┘
                                      │
                                   S50 ↰
```

[Figure 19]

[Figure 20]

[Figure 21]

[Figure 22]

EP 2 579 048 A1

[Figure 23]

(a)

100

101    101

(b)

114
Vehicle operating section

115
Vehicle control section

1

113
Charging circuit

2
Voltage source section

10
Voltage detection section

8
Digital circuit section

Vout

111
Power conversion section

112
Motor

51

[Figure 24]

[Figure 25]

900

Object of
measurements:
analog voltage

910

911

912

Input
switching
section

AD
converter the
unit

Object of
measurements

913

Reference
voltage

Comparison
section

Digital voltage
value

Reference voltage value

[Figure 26]

[Figure 27]

<table>
<tr><td colspan="2" align="center">**INTERNATIONAL SEARCH REPORT**</td><td colspan="2">International application No.<br>PCT/JP2011/061274</td></tr>
</table>

A. CLASSIFICATION OF SUBJECT MATTER
*G01R19/00*(2006.01)i

According to International Patent Classification (IPC) or to both national classification and IPC

B. FIELDS SEARCHED

Minimum documentation searched (classification system followed by classification symbols)
G01R19/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-58244 A (Makita Corp.),<br>18 March 2010 (18.03.2010),<br>entire text; all drawings<br>& US 2010/0063757 A1 & EP 2161809 A2<br>& CN 101667742 A | 1-15 |
| A | JP 2008-64520 A (Hitachi Vehicle Energy, Ltd.),<br>21 March 2008 (21.03.2008),<br>entire text; all drawings<br>(Family: none) | 1-15 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>15 August, 2011 (15.08.11) | Date of mailing of the international search report<br>23 August, 2011 (23.08.11) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 579 048 A1**

**Patent documents cited in the description**

- JP H10209864 B

- JP H8303292 B